# EUROPEAN PATENT APPLICATION

(11) **EP 4 711 830 A1**
(43) Date of publication of application: **18.03.2026**
(21) Application number: 25179626.4
(22) Date of filing: 28.05.2025
(51) Int. Cl.: G02B 6/42

(54) **SEMICONDUCTOR PACKAGE**

(30) Priority: 13.09.2024 KR 20240126151
(71) Applicant: Samsung Electronics Co., Ltd., Suwon-si, Gyeonggi-do 16677 (KR)
(72) Inventor: KANG, Junghoon, 16677 Suwon-si (KR)
(74) Representative: Marks & Clerk LLP

(57) **Abstract**

A semiconductor package includes a first substrate having a first and second bottom surfaces located at different vertical levels from a top surface of the first substrate, a first semiconductor chip on the top surface of the first substrate, a second semiconductor chip on the first bottom surface and including a photonic integrated circuit, and a second substrate on the second bottom surface to cover the second semiconductor chip. The first substrate includes: a first via vertically penetrating the first substrate and electrically connecting the first semiconductor chip to the second semiconductor chip; a second via vertically penetrating the first substrate and electrically connecting the first semiconductor chip to the second substrate; and an optical waveguide on the first bottom surface. A first distance from the top surface to the first bottom surface is smaller than a second distance from the top surface to the second bottom surface.

## Description

### FIELD

The present disclosure relates to a semiconductor package and a method of fabricating the same, and in particular, to a semiconductor package including an optical device and a method of fabricating the same.

### BACKGROUND

With the recent advance in the electronics industry, the demand for high-performance, high-speed, and compact electronic components is increasing. To meet this demand, packaging technologies for mounting a plurality of semiconductor chips in a single package are being developed.

Recently, the demand for portable electronic devices has been rapidly increasing in the market, and thus, it is necessary to reduce sizes and weights of electronic components constituting the portable electronic devices. In order to achieve this, it is necessary to develop packaging technologies for reducing a size and a weight of each component and for integrating a plurality of individual components in a single package. In particular, for a semiconductor package integrated with multiple devices, such as optical devices in addition to the electronic device, the semiconductor package should be developed to have structural, electrical, and optical characteristics that meet the required characteristics and functions of the devices.

### SUMMARY

Some embodiments disclosed herein may provide a semiconductor package with an increased integration density and a reduced size.

Some embodiments disclosed herein may provide a semiconductor package with improved electrical characteristics.

According to some embodiments, a semiconductor package includes a first substrate having a first bottom surface and a second bottom surface, which are located at different vertical levels from a top surface of the first substrate, a first semiconductor chip mounted on the top surface of the first substrate, a second semiconductor chip mounted on the first bottom surface of the first substrate, the second semiconductor chip including a photonic integrated circuit, and a second substrate disposed on the second bottom surface of the first substrate to cover the second semiconductor chip. The first substrate may include a first via vertically penetrating the first substrate and electrically connecting the first semiconductor chip to the second semiconductor chip, a second via vertically penetrating the first substrate and electrically connecting the first semiconductor chip to the second substrate, and an optical waveguide on the first bottom surface. A first distance from the top surface of the first substrate to the first bottom surface is smaller than a second distance from the top surface of the first substrate to the second bottom surface.

According to some embodiments, a semiconductor package includes a first substrate including a core portion formed of glass and an interconnection layer provided on a top surface of the core portion, the core portion having a recess region, which is formed on a bottom surface of the core portion and is in contact with a side surface of the core portion, a first semiconductor chip disposed on the interconnection layer, a second semiconductor chip disposed on a bottom surface of the recess region, the second semiconductor chip including a photonic integrated circuit, a cover portion provided on the bottom surface of the recess region to cover the second semiconductor chip, and a second substrate covering a bottom surface of the cover portion and the bottom surface of the core portion. The bottom surface of the core portion may be located at a level lower than the bottom surface of the cover portion. The core portion may include an optical waveguide provided on the bottom surface of the recess region. The optical waveguide extends toward the side surface of the core portion from a first region between the second semiconductor chip and the core portion to a second region beside the second semiconductor chip. The second semiconductor chip is optically coupled to the optical waveguide.

According to some embodiments, a semiconductor package includes a first substrate, a first semiconductor chip mounted on a top surface of the first substrate, second semiconductor chips mounted on a bottom surface of the first substrate, a second substrate provided on bottom surfaces of the second semiconductor chips, a vertical connecting portion provided between the second semiconductor chips to electrically connect the first substrate to the second substrate, and cover portions disposed between the first substrate and the second substrate. The first substrate may include optical waveguides provided on the bottom surface of the first substrate. The optical waveguides extend from first regions overlapping the second semiconductor chips to second regions beside the second semiconductor chips. The cover portions are disposed on respective portions of the second semiconductor chips. The cover portions are vertically spaced apart from the optical waveguides. Spaces between the optical waveguides and the cover portions constitute sockets.

At least some of the above and other features of the invention are set out in the claims.

### BRIEF DESCRIPTION OF THE DRAWINGS

FIG. 1 is a sectional view illustrating a semiconductor package according to some embodiments.
FIG. 2 is a plan view illustrating a semiconductor package according to some embodiments.
FIGS. 3 and 4 are sectional views illustrating a semiconductor package according to some embodiments.
FIGS. 5 and 6 are plan views illustrating a semiconductor package according to some embodiments.
FIGS. 7 to 17 are sectional views illustrating a semiconductor package according to some embodiments.
FIGS. 18 to 23 are sectional views illustrating a method of fabricating a semiconductor package according to some embodiments.

### DETAILED DESCRIPTION

Hereinafter, with reference to the accompanied drawings, embodiments of the present disclosure will be described in more detail. The same reference numerals are used for the same components in the drawings, and redundant descriptions of the same components are omitted.

It should be understood that the embodiments described herein are intended to implement various features of the present disclosure. These are only examples and are not intended to be limiting. For example, the dimensions of the components are not limited to the disclosed ranges or values and may vary depending on process conditions and/or the properties of a desired device. For example, the formation of a first structure over or on a second structure in the description that follows may include embodiments in which the first and second structures are formed in direct contact, and may also include embodiments in which additional structures may be formed between the first and second structures such that the first and second structures may not be in direct contact. For simplicity and clarity, various structures may be drawn arbitrarily at different scales.

Further, spatially relative terms, such as "under," "below," "lower," "over," "upper", "top", "bottom", etc., may be used herein for ease of description to describe one element or relationship of structures to another element or structure as illustrated in the drawings. It will be appreciated that these terms are relative to the structure of the device, and need not imply any particular orientation of the device in use. For instance, a vertical axis may be defined perpendicular to a top surface of the first substrate. The vertical axis may define an axis for measuring relative heights (relative vertical levels) within the device. For instance, a top surface of a component may be located further along the vertical axis than (e.g. "above") a bottom surface of the component. A horizontal plane may be defined parallel to the top surface of the first substrate.

Additionally, ordinal numbers such as "first," "second," "third," etc. may be used as labels for specific elements, steps, directions, etc. to distinguish various elements, steps, directions, etc. from each other. Terms that are not described using "first," "second," etc. in the specification may still be referred to as "first" or "second" in the claims. Additionally, terms (for example, "first" in a particular claim) referenced by a particular ordinal number may be described elsewhere with a different ordinal number (for example, "second" in the specification or another claim).

The terms "comprises," "comprising," "includes" and/or "including," when used herein, specify the presence of stated elements, but do not preclude the presence of additional elements.

The term "and/or" includes any and all combinations of one or more of the associated listed items.

The term "connected" may be used herein to refer to a physical and/or electrical connection. A electrical connection between two components may be a direct electrical connection (e.g. where the two components are in direct contact) or an indirect electrical connection (e.g. where one or more intervening components are located between the two components).

A first element described as "on" a second element may be disposed directly on the second element (e.g., in contact with the second element) or indirectly on the second element (e.g., with an intervening element interposed between the first and second elements). When components or layers are referred to herein as "directly" on, or "in direct contact" or "directly connected," no intervening components or layers are present.

Also, expressions described in the singular may be interpreted as singular or plural unless explicit expressions such as "one" or "single" are used. Terms that include ordinal numbers such as first, second, etc. may be used to describe various components, but the components are not limited by these terms. These terms may be used for the purpose of distinguishing one component from another.

In addition, throughout the specification, when referring to "a plan view", it means that the target portion is viewed from above or below (e.g. viewed along a direction parallel to the vertical axis), and when referring to "a sectional view" or "a cross-section view", it means that a cross section of the target portion cut vertically is viewed from a side (e.g. viewed along a direction that crosses (e.g. that is perpendicular to) the vertical axis).

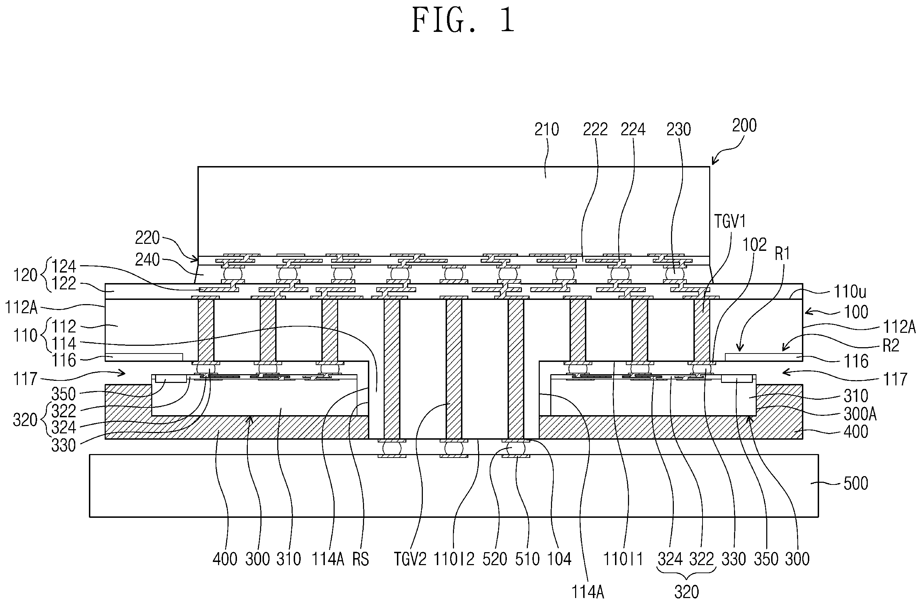

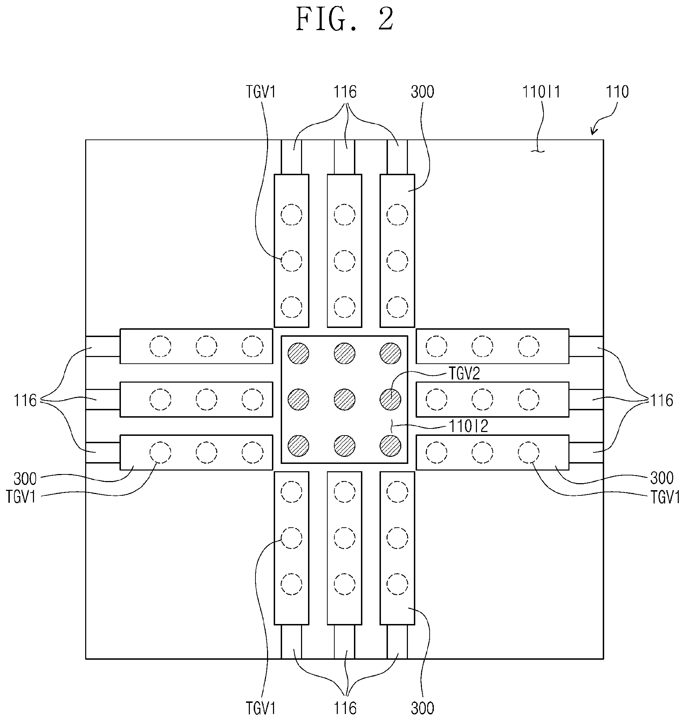

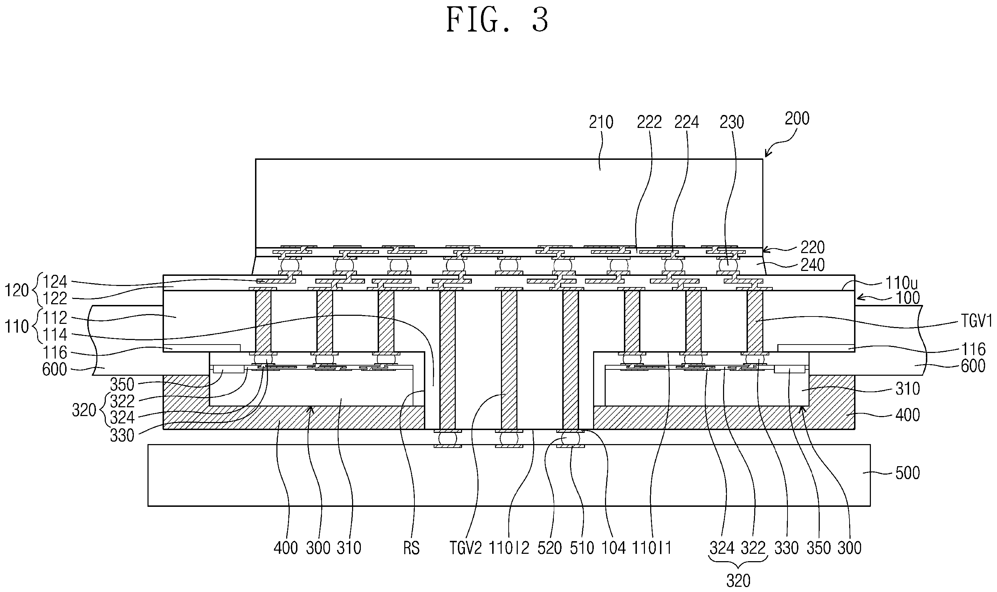

FIG. 1 is a sectional view illustrating a semiconductor package according to some embodiments. FIG. 2 is a plan view illustrating a semiconductor package according to some embodiments and is a bottom plan view illustrating a first substrate and second semiconductor chips, which are mounted on a bottom surface of the first substrate. FIG. 3 is a sectional view illustrating a semiconductor package according to some embodiments.

Referring to FIGS. 1 and 2, a first substrate 100 may be provided. The first substrate 100 may include a first core portion 110 and an interconnection layer 120.

The first core portion 110 may include an electrically insulating material. For example, the first core portion 110 may include glass fibers. In other words, the first substrate 100 may be a glass-based wiring substrate.

The first core portion 110 may have a top surface 110u and first and second bottom surfaces 11011 and 110l2, which are opposite to the top surface 110u. The first and second bottom surfaces 11011 and 110l2 may be located at different vertical levels, when measured from the top surface 110u. This will be described in more detail below. The first core portion 110 may include a horizontal portion 112 and a protruding portion 114, which is disposed below the horizontal portion 112.

The horizontal portion 112 may have a plate-shaped structure. The top surface 110u of the horizontal portion 112 may correspond to the top surface 110u of the first core portion 110. The protruding portion 114 may protrude from the bottom surface 11011 of the horizontal portion 112. The bottom surface 110l2 of the protruding portion 114 may be located at a level lower than the bottom surface 11011 of the horizontal portion 112. In other words, the bottom surface 110l2 of the protruding portion 114 may be farther from the top surface 110u of the first core portion 110 than the bottom surface 11011 of the horizontal portion 112 is. The bottom surface 110l2 of the protruding portion 114 may correspond to the first bottom surface 110l2 of the first core portion 110. The bottom surface 11011 of the horizontal portion 112, which is not covered with the protruding portion 114 and is exposed (e.g. exposed to the outside of the first core portion 110), may correspond to the second bottom surface 11011 of the first core portion 110. The term "exposed" may refer to a section that is not covered by a particular component, but may nevertheless be covered by other components (e.g. the bottom surface 11011 that is not covered by the protruding portion 114 is exposed relative to the protruding portion 114, but may still be covered by other components, such as the second semiconductor chips 300). A thickness of the first core portion 110 on the first bottom surface 11011 may be smaller than a thickness of the first core portion 110 on the second bottom surface 110l2. When viewed in a plan view, the protruding portion 114 may be positioned or located such that it overlaps a center portion of the horizontal portion 112. The protruding portion 114 may be spaced apart from side surfaces 112A of the horizontal portion 112. Thus, the first core portion 110 may have a T-shaped section (e.g. when viewed in cross-section).

That is, the first core portion 110 may have a recess region RS, which is formed in a lower portion of the first core portion 110. When viewed in a plan view, the recess region RS may extend along an edge of the first core portion 110. The recess region RS may intersect or be in contact with the side surfaces 112A of the first core portion 110. The recess region RS may surround the first bottom surface 11011 of the first core portion 110. For example, the recess region RS may have a ring shape extending in the side surfaces of the first core portion 110, when viewed in a plan view. The recess region RS may have a shape that is recessed from the second bottom surface 110l2 of the first core portion 110 in an upward direction. In other words, the first bottom surface 11011 of the first core portion 110 may correspond to a bottom surface 11011 of the recess region RS. The bottom surface 11011 of the recess region RS may be connected to the side surfaces 112A of the first core portion 110.

The first core portion 110 may include first vias TGV1 and second vias TGV2. The first and second vias TGV1 and TGV2 may vertically penetrate the first core portion 110. Where the first core portion 110 is formed of glass, the first vias TGV1 and the second vias TGV2 may be called "through glass vias".

The first vias TGV1 may connect the top surface 110u of the first core portion 110 to the first bottom surface 11011. Top surfaces of the first vias TGV1 may be exposed to the outside of the first core portion 110 through the top surface 110u, and bottom surfaces of the first vias TGV1 may be exposed to the outside of the first core portion 110 through the first bottom surface 11011. The top surfaces of the first vias TGV1 may be substantially flat and may be substantially coplanar with the top surface 110u of the first core portion 110, and the bottom surfaces of the first vias TGV1 may be substantially flat and may be substantially coplanar with the first bottom surface 11011 of the first core portion 110.

The second vias TGV2 may connect the top surface 110u of the first core portion 110 to the second bottom surface 110l2. Top surfaces of the second vias TGV2 may be exposed to the outside of the first core portion 110 near (e.g. through) the top surface 110u of the first core portion 110, and bottom surfaces of the second vias TGV2 may be exposed to the outside of the first core portion 110 near (e.g. through) the second bottom surface 110l2 of the first core portion 110. The top surfaces of the second vias TGV2 may be substantially flat and may be substantially coplanar with the top surface 110u of the first core portion 110, and the bottom surfaces of the second vias TGV2 may be substantially flat and may be substantially coplanar with the second bottom surface 110l2 of the first core portion 110.

Since the second bottom surface 110l2 is located at a vertical level lower than the first bottom surface 11011, a vertical length of the second vias TGV2 may be larger than a vertical length of the first vias TGV1. The first and second vias TGV1 and TGV2 may include electrically conductive material. For example, the first and second vias TGV1 and TGV2 may be formed of or include at least one metallic material (e.g., copper (Gu) or tungsten (W)).

The first core portion 110 may have waveguides 116, which are provided in a lower portion of the first core portion 110. The waveguides 116 may be provided on the first bottom surface 11011 of the first core portion 110 (e.g. within the first core portion 110). The waveguides 116 may be disposed adjacent to side surfaces 112A of the horizontal portion 112 of the first core portion 110. The waveguides 116 may be placed between the side surfaces 112A of the horizontal portion 112 of the first core portion 110 and the first vias TGV1. In other words, the waveguides 116 may be closer to the side surfaces 112A of the horizontal portion 112 of the first core portion 110 than the first vias TGV1. The waveguides 116 may have a bar shape. When viewed in a plan view, each of the waveguides 116 may be a line-shaped structure extending from one of the side surfaces 112A of the horizontal portion 112 towards the protruding portion 114. FIG. 2 illustrates an example, in which three waveguides 116 are provided on each side surface 112A of the horizontal portion 112, but the inventive embodiments are not limited to this example. The arrangement and number of the waveguides 116 may be variously changed, if necessary. Bottom surfaces of the waveguides 116 may be portions of the first bottom surface 11011 of the first core portion 110. In other words, the bottom surfaces of the waveguides 116 may be coplanar with the first bottom surface 11011 of the first core portion 110. For instance, the waveguides 116 may be recessed within the first bottom surface 11011.

The waveguide 116 may be a glass optical waveguide, which is formed on the first bottom surface 11011 of the first core portion 110. In some embodiments, the waveguides 116 may be formed of or include the same material as the first core portion 110. The waveguides 116 may be formed of or include glass. In more detail, the waveguides 116 may include glass, and some of elements constituting the glass may be substituted with other elements. In some embodiments, the waveguides 116 may be formed of or include glass, in which a +1 alkali element (e.g. an alkali element (e.g. an alkali metal) from Group 1 of the periodic table) is substituted with another +1 element (e.g. another element from Group 1 of the periodic table).

The first core portion 110 may have first substrate pads 102 and second substrate pads 104, which are provided below the first core portion 110. The first substrate pads 102 may be disposed on the first bottom surface 11011 of the first core portion 110. Each of the first substrate pads 102 may be coupled to a bottom surface of a corresponding one of the first vias TGV1. The first substrate pads 102 may be electrically connected to the interconnection layer 120 through the first vias TGV1. The first substrate pads 102 may be used for the coupling with second semiconductor chips 300 to to be described below. The second substrate pads 104 may be disposed on the second bottom surface 110l2 of the first core portion 110. The second substrate pads 104 may be coupled to the bottom surfaces of the second vias TGV2, respectively. The second substrate pads 104 may be electrically connected to the interconnection layer 120d through the second vias TGV2. The second substrate pads 104 may be used for the coupling with a second substrate 500 to be described below. The first substrate pads 102 and the second substrate pads 104 may include a metallic material (e.g., copper (Cu)).

The interconnection layer 120 may be disposed on the top surface 110u of the first core portion 110. The interconnection layer 120 may cover the entire top surface 110u of the first core portion 110. The interconnection layer 120 may have side surfaces that are aligned or flush with side surfaces 112A of the first core portion 110. The interconnection layer 120 may include a first insulating layer 122 and a first interconnection portion 124.

The top surface 110u of the first core portion 110 may be covered with the first insulating layer 122. The first insulating layer 122 may cover the top surfaces of the first and second vias TGV1 and TGV2, which are formed in the first core portion 110. In other words, the first and second vias TGV1 and TGV2 may be veiled or covered by the first insulating layer 122 and may not be exposed to the outside. The first insulating layer 122 may include an electrically insulating material. For example, the first insulating layer 122 may include an electrically insulating polymer or a photo-imageable dielectric (PID) material. Alternatively, the first insulating layer 122 may be formed of or include at least one of silicon oxide (SiO), silicon nitride (SiN), or silicon oxynitride (SiON).

The first interconnection portion 124, which is electrically connected to the first and second vias TGV1 and TGV2, may be provided in the first insulating layer 122. The first interconnection portion 124 may include interconnection patterns, which are buried in the first insulating layer 122. For example, the interconnection patterns may include redistribution patterns for horizontal interconnection and via patterns for vertical interconnection. The first interconnection portion 124 may be located between top and bottom surfaces of the first insulating layer 122. The first interconnection portion 124 may vertically penetrate the first insulating layer 122 and may electrically connect the first and second vias TGV1 and TGV2 to each other. Portions of the first interconnection portion 124 may be exposed to a region on the top surface of the first insulating layer 122, and the exposed portions of the first interconnection portion 124 may serve as first upper substrate pads of the interconnection layer 120. In some embodiments, the first interconnection portion 124 may be formed of or include conductive material, such as copper (Cu) or tungsten (W).

A first semiconductor chip 200 may be disposed on the first substrate 100. The first semiconductor chip 200 may include a first chip base layer 210 and a first chip interconnection layer 220.

The first chip base layer 210 may include a semiconductor substrate. For example, the first chip base layer 210 may be a semiconductor substrate (e.g., a semiconductor wafer). A first integrated circuit may be provided on a bottom surface of the first chip base layer 210. The first integrated circuit may include a logic circuit. For instance, the first semiconductor chip 200 may be a logic chip. For example, the first semiconductor chip 200 may be an application specific integrated circuit (ASIC), a central processing unit (CPU), a graphics processing unit (GPU), or an application processor (AP). Alternatively, the first integrated circuit may include a memory circuit. For instance, the first semiconductor chip 200 may be a memory chip. For example, the first semiconductor chip 200 may be one of a dynamic random-access memory (DRAM) chip, a static random-access memory (SRAM) chip, and a NAND FLASH memory chip. A bottom surface of the first semiconductor chip 200 may be an active surface, and a top surface of the first semiconductor chip 200 may be an inactive surface. In other words, the first semiconductor chip 200 may be disposed on the first substrate 100 in a face down shape (e.g. a face down arrangement). An active surface may be a surface in or on which electronic components (e.g. active components) are located.

The first chip interconnection layer 220 may be disposed on the bottom surface of the first chip base layer 210. For example, the first chip interconnection layer 220 may include a first chip insulating pattern 222 and a first chip interconnection pattern 224 formed on the bottom surface of the first chip base layer 210. In some embodiments, the first chip interconnection layer 220 may further include a circuit pattern or a protection layer.

The first chip insulating pattern 222 may be provided on the bottom surface of the first chip base layer 210 to cover the first integrated circuit. The first chip insulating pattern 222 may include at least one electrically insulating material. In some embodiments, the first chip insulating pattern 222 may be formed of or include at least one of silicon oxide (SiO), silicon nitride (SiN), or silicon oxynitride (SiON).

The first chip interconnection pattern 224 may be provided in the first chip insulating pattern 222. The first chip interconnection pattern 224 may be electrically connected to the first integrated circuit, which is formed on the bottom surface of the first chip insulating pattern 222. The first chip interconnection pattern 224 may include an electrically conductive material. The first chip interconnection pattern 224 may include a metallic material (e.g., copper (Cu)). Portions of the first chip interconnection pattern 224, which are exposed to the outside of the first chip interconnection layer 220 near a bottom surface of the first chip interconnection layer 220, may be first chip pads of the first semiconductor chip 200.

The first semiconductor chip 200 may be mounted on the first substrate 100. For example, the first semiconductor chip 200 may be mounted on the first substrate 100 in a flip chip manner. In more detail, the first semiconductor chip 200 may be electrically connected to the first substrate 100 through first connection terminals 230. The first connection terminals 230 may be provided between the first chip pads of the first semiconductor chip 200 and the first upper substrate pads of the first substrate 100. The first semiconductor chip 200 may be electrically connected to the interconnection layer 120 of the first substrate 100 through the first connection terminals 230.

An under-fill layer 240 may be provided between the first substrate 100 and the first semiconductor chip 200. The under-fill layer 240 may fill a space between the first substrate 100 and the first semiconductor chip 200 and may enclose the first connection terminals 230.

At least one second semiconductor chip 300 may be disposed below the first substrate 100. The second semiconductor chip 300 may be disposed on the first bottom surface 11011 of the first core portion 110 of the first substrate 100. The second semiconductor chip 300 may be placed next to the protruding portion 114 of the first core portion 110. When viewed in a plan view, the second semiconductor chip 300 may be placed or disposed between a side surface 114A of the protruding portion 114 of the first core portion 110 and the side surface 112A of the horizontal portion 112 of the first core portion 110. The second semiconductor chip 300 may be horizontally spaced apart from the side surface 114A of the protruding portion 114 of the first core portion 110. However, the inventive embodiments are not limited to this example, and in some embodiments, the second semiconductor chip 300 may be in contact with the side surface 114A of the protruding portion 114 of the first core portion 110. The second semiconductor chip 300 may be horizontally spaced apart from the side surface 112A of the horizontal portion 112 of the first core portion 110. At least a portion of the second semiconductor chip 300 may be vertically overlapped with one or more of the waveguides 116 of the first core portion 110. In the case where a plurality of second semiconductor chips 300 are provided, each of the second semiconductor chips 300 may be overlapped with one of the waveguides 116. That is, each of the waveguides 116 may extend from one of the side surfaces 112A of the horizontal portion 112 of the first core portion 110 to a region on a top surface of one of the second semiconductor chips 300. Each waveguide 116 may extend in a direction toward the side surface 112A of the horizontal portion 112 from a first region R1 between the second semiconductor chip 300 and the core portion 110 to a second region R2 laterally beside or adjacent the second semiconductor chip 300, between the first region R1 and the side surface 112A of the horizontal portion 112 (FIG. 1). Each waveguide 116 may extend through or across both the first region R1 and the second region R2. Each waveguide 116 may overlap, in plan view, its corresponding second semiconductor chip 300 in the first region R1. FIG. 2 illustrates an example, in which three second semiconductor chips 300 are provided on each of the side surfaces 112A of the horizontal portion 112 depending on the number and arrangement of the waveguides 116, but the inventive embodiments are not limited to this example. In some embodiments, the number and arrangement of the second semiconductor chips 300 may be variously changed. A bottom surface of the second semiconductor chip 300 may be located at a vertical level higher than the bottom surface of the protruding portion 114 of the first core portion 110 (i.e., the second bottom surface 110l2).

Hereinafter, the structure of the second semiconductor chip 300 will be described in more detail with reference to one of the second semiconductor chips 300. The second semiconductor chip 300 may include a second chip base layer 310 and a second chip interconnection layer 320.

The second chip base layer 310 may include a semiconductor substrate. For example, the second chip base layer 310 may be a semiconductor substrate (e.g., a semiconductor wafer). A second integrated circuit may be provided on a top surface of the second chip base layer 310. The second integrated circuit may include a photonic integrated circuit (PIC). In other words, the second semiconductor chip 300 may be a photonic device. If necessary, the second integrated circuit may further include an electronic integrated circuit (EIC). A top surface of the second semiconductor chip 300 may be an active surface, and the bottom surface of the second semiconductor chip 300 may be an inactive surface. In other words, the second semiconductor chip 300 may be disposed in a face up manner.

The second chip interconnection layer 320 may be disposed on the top surface of the second chip base layer 310. For example, the second chip interconnection layer 320 may include a second chip insulating pattern 322 and a second chip interconnection pattern 324 formed on the top surface of the second chip base layer 310. In some embodiments, the second chip interconnection layer 320 may further include a circuit pattern or a protection layer.

The second chip insulating pattern 322 on the top surface of the second chip base layer 310 may cover the second integrated circuit. The second chip insulating pattern 322 may include an electrically insulating material. In some embodiments, the second chip insulating pattern 322 may be formed of or include at least one of silicon oxide (SiO), silicon nitride (SiN), or silicon oxynitride (SiON).

The second chip interconnection pattern 324 may be provided in the second chip insulating pattern 322. The second chip interconnection pattern 324 may be electrically connected to the second integrated circuit, which is formed on the top surface of the second chip insulating pattern 322. The second chip interconnection pattern 324 may include an electrically conductive material. In some embodiments, the second chip interconnection pattern 324 may include a metallic material (e.g., copper (Cu)). Portions of the second chip interconnection pattern 324, which are exposed to a region on a top surface of the second chip interconnection layer 320, may be second chip pads of the second semiconductor chip 300.

The second semiconductor chip 300 may further include a sensor unit 350. The sensor unit 350 may be formed or disposed on the second chip base layer 310. The sensor unit 350 may be exposed to a region on the top surface of the second chip interconnection layer 320. The sensor unit 350 may be electrically connected to the second integrated circuit formed on the second chip base layer 310. The sensor unit 350 may be disposed adjacent to one of side surfaces of the second semiconductor chip 300. The sensor unit 350 may be disposed adjacent to a side surface of the second semiconductor chip 300 that faces away from the protruding portion 114. The sensor unit 350 may be vertically overlapped with one of the waveguides 116 of the first core portion 110 of the first substrate 100. The sensor unit 350 may be configured to sense light (e.g. light from the one of the waveguides 116). For instance, the sensor unit 350 may be a light sensor. The sensor unit 350 may be optically coupled to the one of the waveguides 116. The sensor unit 350 may be configured to receive light from the one of the waveguides 116 and to convert the light to electrical signals.

The second semiconductor chips 300 may be mounted on the first substrate 100. For example, the second semiconductor chips 300 may be mounted on the first substrate 100 in a flip chip manner. In more detail, the second semiconductor chips 300 may be electrically connected to the first substrate 100 through second connection terminals 330. The second connection terminals 330 may be provided between the second chip pads of the second semiconductor chip 300 and the first substrate pads 102 of the first substrate 100. The second semiconductor chip 300 may be electrically connected to the first vias TGV1 of the first substrate 100 through the second connection terminals 330. The second semiconductor chip 300 may be electrically connected to the first semiconductor chip 200 through the first substrate 100.

According to some embodiments, the waveguides 116, which are configured to receive optical signals from the outside, may be provided on the first substrate 100. The second semiconductor chips 300, which are configured to input, output, and process the optical signal and to convert the optical signal to an electrical signal, may be connected to the first bottom surface 11011 of the first substrate 100. The first semiconductor chip 200, which is configured to process the electrical signal, may be connected to a top surface 100u of the first substrate 100. The first and second semiconductor chips 200 and 300 may be electrically connected to each other through the first vias TGV1 and the interconnection layer 120. That is, the first substrate 100 may be configured to provide an optical path from the outside toward each of the second semiconductor chips 300 and an electrical path from each of the second semiconductor chips 300 toward the first semiconductor chip 200, and the semiconductor package may have a simple structure, a small size, and a high integration density.

Since the recess region RS is formed in the first substrate 100 and the second semiconductor chips 300 are placed within the recess region RS, a distance from a top surface of the first substrate 100 to bottom surfaces of the second semiconductor chips 300 or a distance from the top surface of the first substrate 100 to the second bottom surface 110l2 of the first substrate 100 may be reduced. Thus, it may be possible to reduce a size of the semiconductor package.

In addition, the first substrate 100 may have a small thickness between the first and second semiconductor chips 200 and 300, and thus, the first vias TGV1 electrically connecting the second semiconductor chips 300 to the first semiconductor chip 200 may have a small vertical height. That is, an electric connection path between the first and second semiconductor chips 200 and 300 may have a reduced length, and thus, a semiconductor package with improved electrical characteristics may be provided.

Referring further to FIGS. 1 and 2, a cover portion 400 may be disposed below the first substrate 100. The cover portion 400 may be disposed on the first bottom surface 11011 of the first substrate 100. The cover portion 400 on the first bottom surface 11011 of the first substrate 100 may cover the second semiconductor chips 300. The cover portion 400 may be in contact with the bottom surface of the second semiconductor chips 300. Although not shown, the cover portion 400 may be attached to the bottom surface of the second semiconductor chips 300 using an adhesive agent. The cover portion 400 may not cover the second bottom surface 110l2 of the first substrate 100. In other words, the second bottom surface 110l2 of the first substrate 100 may be exposed to the outside of the cover portion 400 through the bottom surface of the cover portion 400. When viewed in a plan view, the cover portion 400 may surround the protruding portion 114 of the first core portion 110. The bottom surface of the cover portion 400 may be located at the same vertical level as the second bottom surface 110l2 of the first substrate 100. However, the inventive embodiments are not limited to this example. The bottom surface of the cover portion 400 may be located at a vertical level higher or lower than the second bottom surface 110l2 of the first substrate 100. The cover portion 400 may be in contact with the side surfaces 114A of the protruding portion 114 of the first core portion 110 of the first substrate 100. However, the inventive embodiments are not limited to this example. The cover portion 400 may be horizontally spaced apart from the side surfaces 114A of the protruding portion 114. The cover portion 400 may extend from the bottom surface of the second semiconductor chips 300 to regions on outer side surfaces 300A of the second semiconductor chips 300. Here, the outer side surface of the second semiconductor chip 300 may be defined as one of the side surfaces of the second semiconductor chip 300 facing in the same direction as the side surface of the first substrate 100 (e.g., the side surface 112A of the horizontal portion 112 of the first core portion 110). In other words, one of the side surfaces of the second semiconductor chip 300 facing the protruding portion 114 of the first core portion 110 may be defined as an inner side surface of the second semiconductor chip 300, and the outer side surface of the second semiconductor chip 300 may be opposite to the inner side surface. The sensor unit 350 of the second semiconductor chips 300 may be disposed adjacent to the outer side surface 300A of the second semiconductor chip 300. The cover portion 400 may cover at least a portion of the outer side surface 300A of the second semiconductor chip 300. Here, in a region next to the second semiconductor chips 300 or on the outer side surface 300A of the second semiconductor chip 300, the cover portion 400 may be vertically spaced apart from the waveguides 116 of the first substrate 100. The side surfaces of the cover portion 400 may be vertically aligned to the side surfaces 112A of the first substrate 100. The cover portion 400 may include a material with high thermal conductivity. In some embodiments, the cover portion 400 may be formed of or include a metallic material.

A space between the cover portion 400 and each waveguide 116 may be a socket 117 (FIG. 1) to be coupled with an external input device. In some embodiments, an external input device 600 or external input devices 600 may be coupled to (for example, inserted or received into) the space or socket 117 between each cover portion 400 and its opposing waveguide 116, as shown in FIG. 3. The external input devices 600 may be an optical device, an optical cable, or an optical input device. The external input devices 600 may be placed next to the second semiconductor chips 300 and may be fastened by the cover portion 400 and the first substrate 100. The external input devices 600 may transmit optical signals to the waveguides 116 of the first substrate 100, and the waveguides 116 may transmit the optical signals to the second semiconductor chips 300 through the sensor units 350.

According to some embodiments, since the cover portion 400 forming the socket 117 is used to fasten the second semiconductor chips 300 to the bottom surface of the first substrate 100, the structural stability of the semiconductor package may be improved. In addition, since the cover portion 400 is formed of a material with high thermal conductivity, heat, which is generated from the second semiconductor chips 300, may be easily exhausted to the outside through the cover portion 400. As a result, a semiconductor package with improved heat-dissipation efficiency may be provided. Hereinafter, the embodiments will be described in more detail with reference to FIGS. 1 and 2.

The second substrate 500 may be provided below the first substrate 100. The second substrate 500 may be provided below the second bottom surface 110l2 of the first substrate 100 and the bottom surface of the cover portion 400. The second substrate 500 may include a printed circuit board (PCB), which includes signal patterns provided on a top surface thereof. The second substrate 500 may include third substrate pads 510, which are disposed on a top surface of the second substrate 500. The third substrate pads 510 may be placed below the second bottom surface 110l2 of the first substrate 100. In some embodiments, the third substrate pads 510 may be aligned to the second substrate pads 104 of the first substrate 100.

The first substrate 100 may be mounted on the second substrate 500. For example, the first substrate 100 may be electrically connected to the second substrate 500 through third connection terminals 520. The third connection terminals 520 may connect the second substrate pads 104 of the first substrate 100 to the third substrate pads 510 of the second substrate 500. The second substrate 500 may be electrically connected to the first substrate 100, the first semiconductor chip 200, and the second semiconductor chips 300 through the third connection terminals 520.

Although not shown, outer terminals may be disposed below the second substrate 500. The outer terminals may include solder balls or solder bumps, and the semiconductor package may be classified into a ball grid array (BGA) package, a fine ball-grid array (FBGA) package, or a land grid array (LGA) package, depending on the kind and arrangement of the outer terminals. In some embodiments, the outer terminals may not be provided.

Hereinafter, an element previously described with reference to FIGS. 1 to 3 may be identified by the same reference number without repeating an overlapping description thereof, for convenience in description. That is, technical features, which are different from those in the embodiments of FIGS. 1 to 3, will be mainly described below.

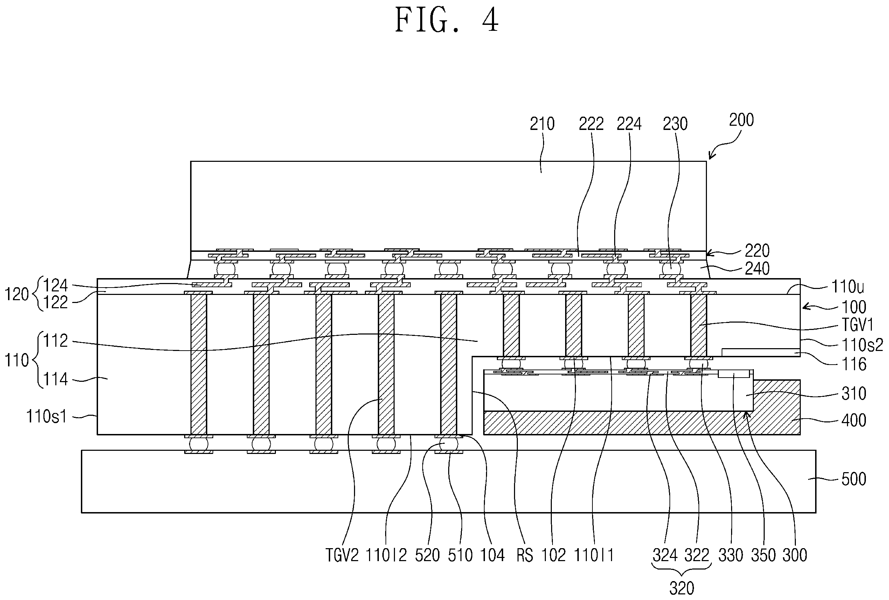

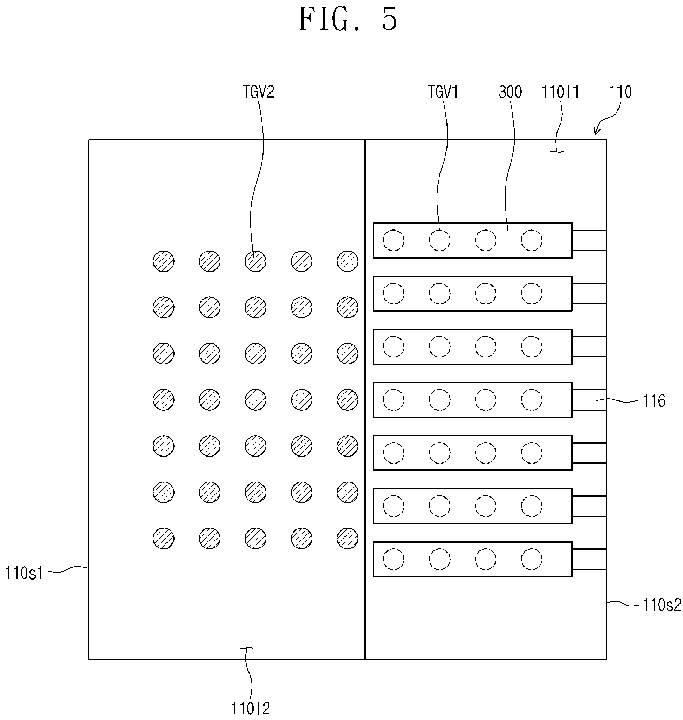

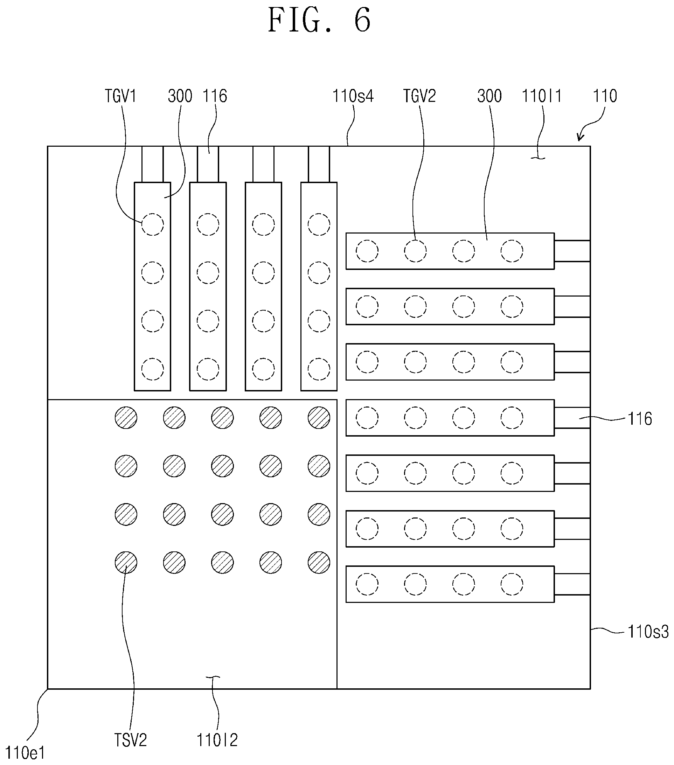

FIG. 4 is a sectional view illustrating a semiconductor package according to some embodiments. FIGS. 5 and 6 are plan views illustrating a semiconductor package according to some embodiments.

Referring to FIGS. 4 and 5, the protruding portion 114 may not be placed on the center portion of the horizontal portion 112. For example, the protruding portion 114 may be disposed adjacent to a first side surface 110s1, which is one of the side surfaces of the first core portion 110 of the first substrate 100. In other words, the first and second bottom surfaces 11011 and 110l2 of the first core portion 110 may be disposed side by side in a horizontal direction. The second bottom surface 110l2 may be disposed adjacent to the first side surface 110s1 of the first core portion 110, and the first bottom surface 11011 may be disposed adjacent to a second side surface 110s2, which is opposite to the first side surface 110s1 of the first core portion 110. Thus, the first core portion 110 may have an inverted L-shaped section (e.g. when viewed in cross-section).

The waveguides 116 of the first core portion 110 may be arranged along the second side surface 110s2 of the first core portion 110, depending on the position of the protruding portion 114. The waveguides 116 may extend from the second side surface 110s2 of the first core portion 110 toward the first side surface 110s1. The second semiconductor chips 300 may be arranged along the second side surface 110s2 of the first core portion 110.

Alternatively, referring to FIGS. 4 and 6, the protruding portion 114 may not be placed on a center portion of the horizontal portion 112. For example, the protruding portion 114 may be disposed adjacent to one 110e1 of corners of the first core portion 110 of the first substrate 100. That is, the protruding portion 114 may be spaced apart from third and fourth side surfaces 110s3 and 110s4 of the first core portion 110, which are not in contact with the corner 110e1 of the first core portion 110. The second bottom surface 110l2 of the first core portion 110 may be disposed adjacent to the corner 110e1 of the first core portion 110, and the second bottom surface 110l2 of the first core portion 110 may extend along the third and fourth side surfaces 110s3 and 110s4.

The waveguides 116 of the first core portion 110 may be arranged along the third or fourth side surface 110s3 or 110s4 of the first core portion 110, depending on the position of the protruding portion 114. The waveguides 116 may extend from the third or fourth side surface 110s3 or 110s4 of the first core portion 110 toward the protruding portion 114. The second semiconductor chips 300 may be arranged along the third or fourth side surface 110s3 or 110s4 of the first core portion 110.

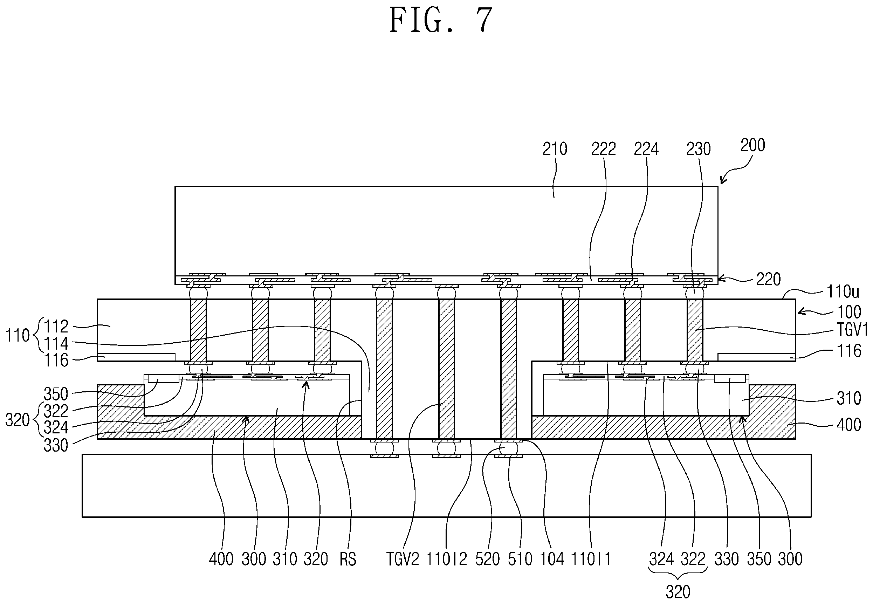

FIG. 7 is a sectional view illustrating a semiconductor package according to some embodiments.

Referring to FIG. 7, the first substrate 100 may not have the interconnection layer 120 (e.g., FIG. 1). For example, the top surface 110u of the first core portion 110 of the first substrate 100 may be the top surface of the first substrate 100. The top surfaces of the first and second vias TGV1 and TGV2 may be exposed to a region on the top surface 110u of the first core portion 110.

The first semiconductor chip 200 may be mounted on the first substrate 100. For example, the first semiconductor chip 200 may be mounted on the first substrate 100 in a flip chip manner. In more detail, the first semiconductor chip 200 may be electrically connected to the first substrate 100 through the first connection terminals 230. The first connection terminals 230 may be electrically connected to the first chip pads of the first semiconductor chip 200. The first connection terminals 230 may be electrically connected to the top surfaces of the first vias TGV1 and the top surfaces of the second vias TGV2, which are exposed to a region on the top surface 110u of the first core portion 110. The first semiconductor chip 200 may be electrically connected to the first and second vias TGV1 and TGV2 through the first connection terminals 230.

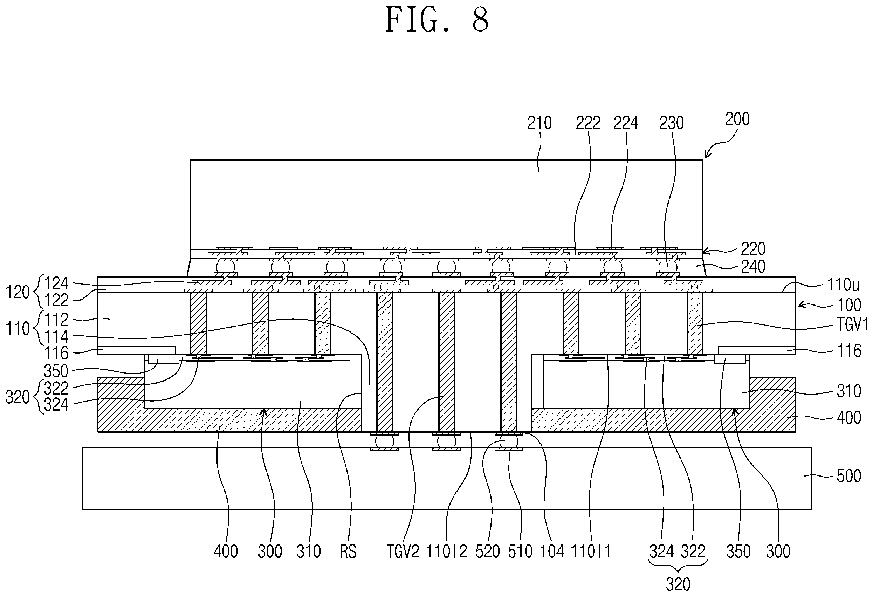

FIG. 8 is a sectional view illustrating a semiconductor package according to some embodiments.

Referring to FIG. 8, the second connection terminals 330 (e.g., see FIG. 1) may not be provided between the first substrate 100 and the second semiconductor chips 300. The first substrate 100 may not comprise the first substrate pads 102 (e.g., see FIG. 1). The first vias TGV1 may be exposed to a region on the first bottom surface 11011 of the first core portion 110 of the first substrate 100.

The second semiconductor chips 300 may be mounted on the first substrate 100. In more detail, the second semiconductor chips 300 may be disposed on the first bottom surface 11011 of the first core portion 110 of the first substrate 100. The active surface of each of the second semiconductor chips 300 may be in contact with the first bottom surface 11011 of the first core portion 110 of the first substrate 100. The second chip pads of the second chip interconnection layer 320 of the second semiconductor chips 300 may be vertically aligned to the first vias TGV1 of the first substrate 100. The second semiconductor chips 300 and the first core portion 110 may be in contact with each other in such a way that the second chip pads and the first vias TGV1 are electrically connected to each other.

The second semiconductor chips 300 may be electrically connected to the first substrate 100. In detail, the second semiconductor chips 300 and the first core portion 110 may be in contact with each other. At an interface between the second semiconductor chips 300 and the first core portion 110, the second chip pads of the second semiconductor chips 300 may be bonded to the first vias TGV1 of the first substrate 100. Here, the second chip pads and the first vias TGV1 may form an intermetal hybrid bonding structure. In the present specification, the hybrid bonding structure may mean a bonding structure that is formed by two materials, which are of the same kind and are fused at an interface therebetween. For example, the second chip pads and the first vias TGV1, which are bonded to each other, may have a continuous structure, and interfaces between the second chip pads and the first vias TGV1 may not be visible or observable. For example, the second chip pads and the first vias TGV1 may be formed of the same material, and thus, there may be no interface between the second chip pads and the first vias TGV1. That is, the second chip pads and the first vias TGV1 may be provided in the form of a single object. For example, the second chip pads and the first vias TGV1 may be electrically and physically connected to each other to form a single object.

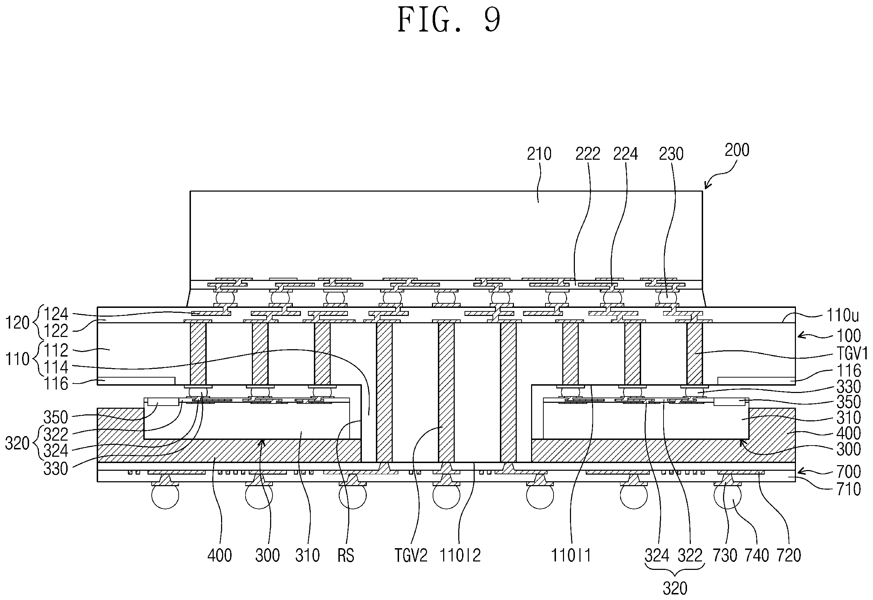

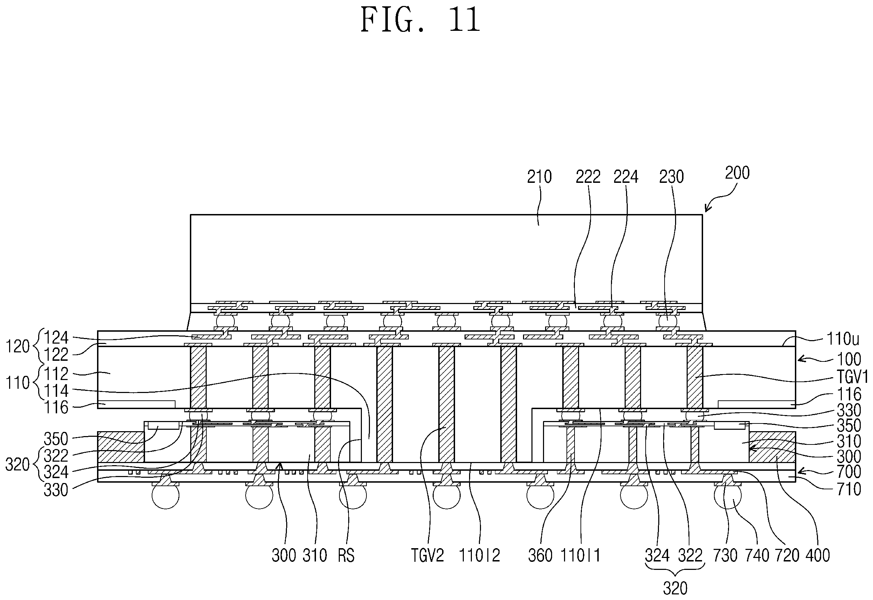

FIGS. 9 to 11 are sectional views illustrating a semiconductor package according to some embodiments.

Referring to FIG. 9, a third substrate 700, not the second substrate 500 (e.g., see FIG. 1), may be provided below the first substrate 100. The third substrate 700 may include a redistribution substrate. The third substrate 700 may include a substrate insulating pattern 710 and a substrate interconnection pattern 720.

The substrate insulating pattern 710 may be disposed on the second bottom surface 110l2 of the first substrate 100 and the bottom surface of the cover portion 400. The substrate insulating pattern 710 may cover the second bottom surface 110l2 of the first substrate 100 and the bottom surface of the cover portion 400. The substrate insulating pattern 710 may be in contact with the second bottom surface 110l2 of the first substrate 100 and the bottom surface of the cover portion 400. The substrate insulating pattern 710 may include an electrically insulating material. For example, the substrate insulating pattern 710 may include at least one of oxide, nitride, or oxynitride materials. In some embodiments, the substrate insulating pattern 710 may be formed of or include at least one of silicon oxide (SiO), silicon nitride (SiN), or silicon oxynitride (SiON).

The substrate interconnection pattern 720, which is electrically connected to the second vias TGV2, may be provided in the substrate insulating pattern 710. The substrate interconnection pattern 720 may include interconnection patterns provided in the substrate insulating pattern 710. For example, the interconnection patterns may include redistribution patterns for horizontal interconnection and via patterns for vertical interconnection. The substrate interconnection pattern 720 may vertically penetrate the substrate insulating pattern 710 on the second bottom surface 110l2 of the first substrate 100 and may be electrically connected to the second vias TGV2. The substrate interconnection pattern 720 may be located between top and bottom surfaces of the substrate insulating pattern 710. In some embodiments, the substrate interconnection pattern 720 may be formed of or include copper (Cu) or tungsten (W).

Fourth substrate pads 730 may be provided on the bottom surface of the substrate insulating pattern 710. The fourth substrate pads 730 may be exposed to the outside of the substrate insulating pattern 710 near the bottom surface of the substrate insulating pattern 710. The fourth substrate pads 730 may protrude to the outside of the substrate insulating pattern 710 near the bottom surface of the substrate insulating pattern 710. Alternatively, the bottom surfaces of the fourth substrate pads 730 may be coplanar with the bottom surface of the substrate insulating pattern 710. The fourth substrate pads 730 may be electrically connected to the substrate interconnection pattern 720. In some embodiments, the fourth substrate pads 730 may be formed of or include copper (Cu) or tungsten (W).

Outer terminals 740 may be provided on a bottom surface of the third substrate 700. The outer terminals 740 may be coupled to the fourth substrate pads 730. The outer terminals 740 may include solder balls or solder bumps, and the semiconductor package may be classified into a ball grid array (BGA) package, a fine ball-grid array (FBGA) package, or a land grid array (LGA) package, depending on the kind and arrangement of the outer terminals 740.

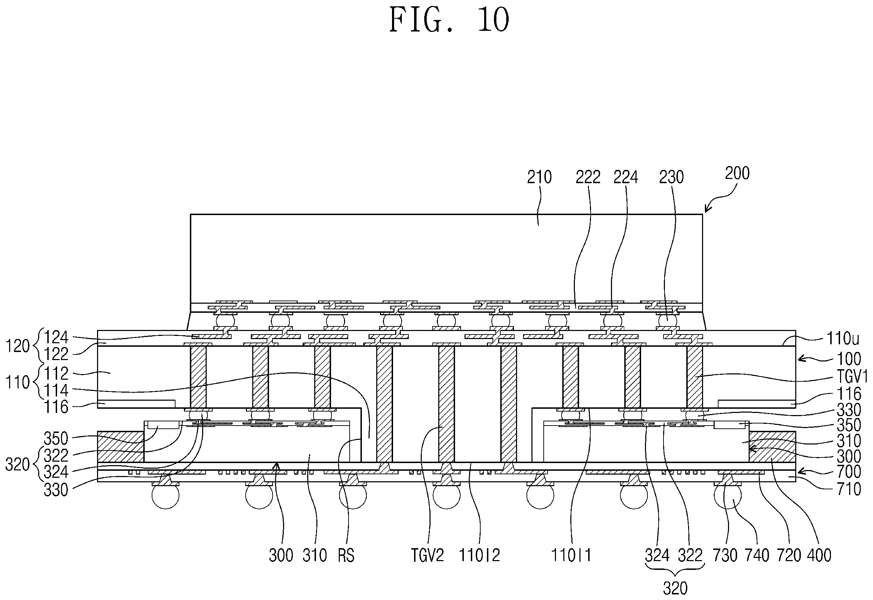

The cover portion 400 may not cover the bottom surface of the second semiconductor chips 300, unlike the embodiment of FIG. 9. As shown in FIG. 10, the cover portion 400 may cover the outer side surface of the second semiconductor chip 300. The cover portion 400 may not extend to a region on the bottom surface of the second semiconductor chips 300. That is, the bottom surface of the second semiconductor chips 300 may be exposed to a region on the bottom surface of the cover portion 400. The bottom surface of the cover portion 400 may be substantially flat and may be substantially coplanar with the bottom surface of the second semiconductor chips 300.

The third substrate 700 may be provided below the first substrate 100, the second semiconductor chips 300, and the cover portion 400. The third substrate 700 may include the substrate insulating pattern 710 and the substrate interconnection pattern 720. The substrate insulating pattern 710 may be in contact with the second bottom surface 110l2 of the first substrate 100, the bottom surface of the second semiconductor chips 300, and the bottom surface of the cover portion 400. The substrate interconnection pattern 720, which is electrically connected to the second vias TGV2, may be provided in the substrate insulating pattern 710. The substrate interconnection pattern 720 may be provided on the second bottom surface 110l2 of the first substrate 100 to vertically penetrate the substrate insulating pattern 710 and may be electrically connected to the second vias TGV2.

Each of the second semiconductor chips 300 may further include chip vias 360 vertically penetrating the second semiconductor chips 300, unlike the embodiment of FIG. 10.

The chip vias 360 may be patterns for vertical interconnection. The chip vias 360 may vertically penetrate the second chip base layer 310 and may be electrically connected to the second chip interconnection layer 320. The chip vias 360 may be exposed to the outside of the second chip base layer 310 near a bottom surface of the second chip base layer 310. Bottom surfaces of the chip vias 360 may be coplanar with the bottom surface of the second chip base layer 310. In some embodiments, the chip vias 360 may be formed of or include tungsten (W).

The third substrate 700 may be provided below the first substrate 100, the second semiconductor chips 300, and the cover portion 400. The third substrate 700 may include the substrate insulating pattern 710 and the substrate interconnection pattern 720. The substrate insulating pattern 710 may be in contact with the second bottom surface 110l2 of the first substrate 100, the bottom surface of the second semiconductor chips 300, and the bottom surface of the cover portion 400. The substrate interconnection pattern 720, which is electrically connected to the second vias TGV2 and the chip vias 360, may be disposed in the substrate insulating pattern 710. The substrate interconnection pattern 720 on the second bottom surface 110l2 of the first substrate 100 may vertically penetrate the substrate insulating pattern 710 and may be electrically connected to the second vias TGV2, and the substrate interconnection pattern 720 on the bottom surface of the second semiconductor chips 300 may vertically penetrate the substrate insulating pattern 710 and may be electrically connected to the chip vias 360.

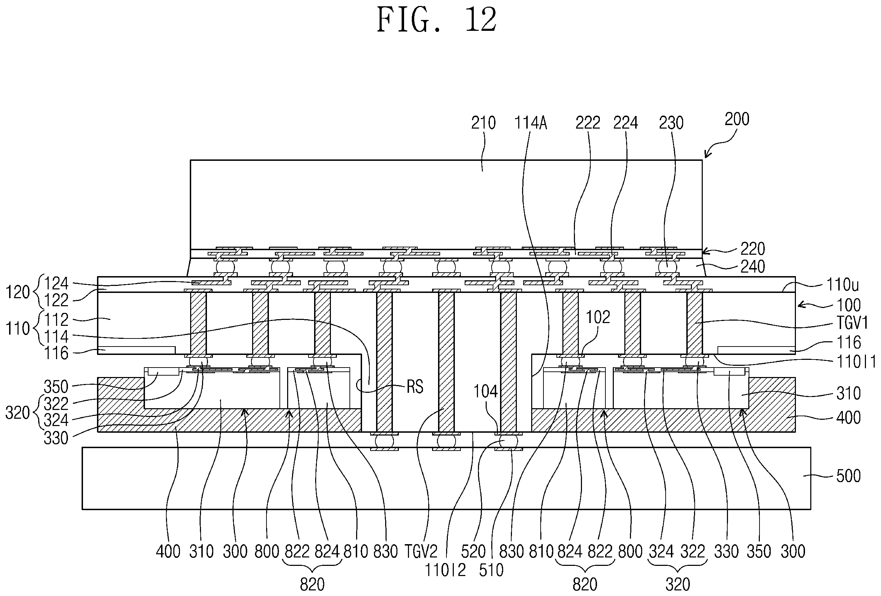

FIGS. 12 to 15 are sectional views illustrating a semiconductor package according to some embodiments.

FIGS. 1 to 11 illustrate the second semiconductor chips 300, which are provided on the first bottom surface 11011 of the first substrate 100 and have photonic integrated circuits (PICs), but the inventive embodiments are not limited to this example.

Referring to FIG. 12, at least one third semiconductor chip 800 may be disposed below the first substrate 100. The third semiconductor chips 800 may be disposed on the first bottom surface 11011 of the first core portion 110 of the first substrate 100. The third semiconductor chips 800 may be placed next to the protruding portion 114 of the first core portion 110. When viewed in a plan view, the third semiconductor chips 800 may be placed between the side surface 114A of the protruding portion 114 of the first core portion 110 and the second semiconductor chips 300. The third semiconductor chips 800 may be horizontally spaced apart from the second semiconductor chips 300. In some embodiments, the arrangement and number of the third semiconductor chips 800 may be variously changed. Bottom surfaces of the third semiconductor chips 800 may be located at a vertical level higher than the second bottom surface 110l2 of the protruding portion 114 of the first core portion 110.

Hereinafter, the structure of the third semiconductor chip 800 will be described in more detail with reference to one of the third semiconductor chips 800. The third semiconductor chip 800 may include a third chip base layer 810 and a third chip interconnection layer 820.

The third chip base layer 810 may include a semiconductor substrate. For example, the third chip base layer 810 may be a semiconductor substrate (e.g., a semiconductor wafer). A third integrated circuit may be provided on a top surface of the third chip base layer 810. The third integrated circuit may include an electronic integrated circuit (EIC). In some embodiments, the third semiconductor chip 800 may be used to drive the second semiconductor chip 300. A top surface of the third semiconductor chip 800 may be an active surface, and a bottom surface of the third semiconductor chip 800 may be an inactive surface. In other words, the third semiconductor chip 800 may be disposed in a face up manner.

The third chip interconnection layer 820 may be disposed on the top surface of the third chip base layer 810. For example, the third chip interconnection layer 820 may include a third chip insulating pattern 822 and a third chip interconnection pattern 824 formed on the top surface of the third chip base layer 810. The third chip interconnection layer 820 may further include a circuit pattern or a protection layer.

The third chip insulating pattern 822 may be provided on the top surface of the third chip base layer 810 to cover the third integrated circuit. The third chip insulating pattern 822 may be formed of or include an electrically insulating material (e.g., silicon oxide (SiO), silicon nitride (SiN), and silicon oxynitride (SiON)).

The third chip interconnection pattern 824 may be provided in the third chip insulating pattern 822. The third chip interconnection pattern 824 may be electrically connected to the third integrated circuit formed on the top surface of the third chip insulating pattern 822. The third chip interconnection pattern 824 may include an electrically conductive material (e.g., copper (Cu)). A portion of the third chip interconnection pattern 824, which is exposed through a top surface of the third chip interconnection layer 820, may be used as third chip pads of the third semiconductor chip 800.

The third semiconductor chip 800 may be mounted on the first substrate 100. For example, the third semiconductor chip 800 may be mounted on the first substrate 100 in a flip chip manner. In more detail, third connection terminals 830 may be provided on the third chip pads of the third semiconductor chips 800. The third semiconductor chip 800 may be electrically connected to the first substrate 100 through the third connection terminals 830. The third connection terminals 830 may be provided between the third chip pads of the third semiconductor chip 800 and the first substrate pads 102 of the first substrate 100. The third semiconductor chip 800 may be electrically connected to the first vias TGV1 of the first substrate 100 through the third connection terminals 830.

The cover portion 400 may be disposed on the first bottom surface 11011 of the first substrate 100. The cover portion 400 on the first bottom surface 11011 of the first substrate 100 may cover the second semiconductor chips 300 and the third semiconductor chips 800.

Unlike the embodiment of FIG. 12, the third semiconductor chips 800 and the second semiconductor chips 300 may be provided in a vertically stacked manner.

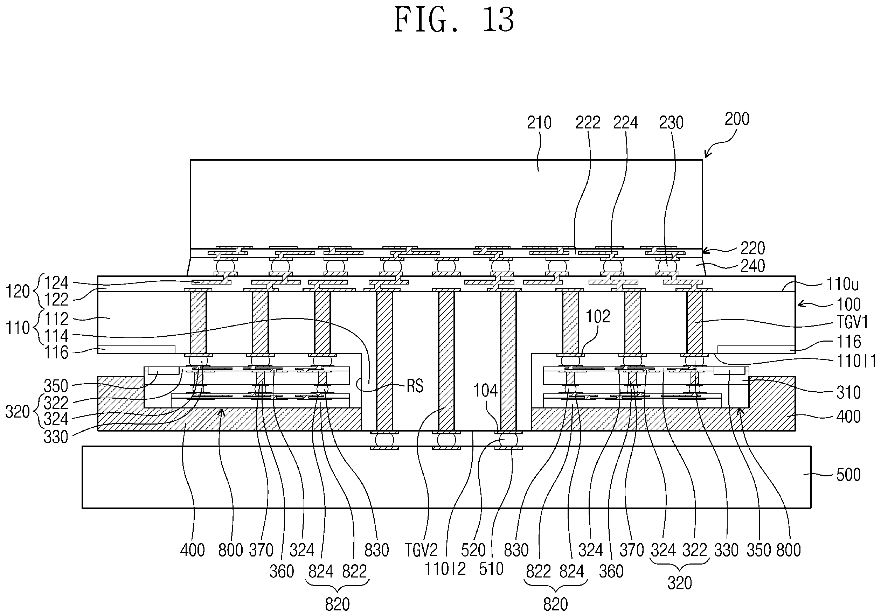

Referring to FIG. 13, each of the second semiconductor chips 300 may further include the chip vias 360 vertically penetrating the second semiconductor chips 300. The chip vias 360 may vertically penetrate the second chip base layer 310 and may be electrically connected to the second chip interconnection layer 320. The chip vias 360 may be exposed to the outside of the second chip base layer 310 through the bottom surface of the second chip base layer 310.

Each of the second semiconductor chips 300 may further include fourth chip pads 370 provided on the bottom surface of the second semiconductor chips 300. The fourth chip pads 370 on the bottom surface of the second semiconductor chips 300 may be coupled to the chip vias 360.

The third semiconductor chips 800 may be disposed on the bottom surface of the second semiconductor chips 300.

The third semiconductor chips 800 may be mounted on the second semiconductor chips 300. For example, the third semiconductor chips 800 may be mounted on the second semiconductor chips 300 in a flip chip manner. In more detail, the third connection terminals 830 may be provided on the third chip pads of the third semiconductor chips 800. The third semiconductor chip 800 may be electrically connected to the second semiconductor chips 300 through the third connection terminals 830. The third connection terminals 830 may be provided between the third chip pads of the third semiconductor chip 800 and the fourth chip pads 370 of the second semiconductor chips 300. The third semiconductor chip 800 may be electrically connected to the chip vias 360 of the second semiconductor chips 300 through the third connection terminals 830.

The cover portion 400 may be disposed on the first bottom surface 11011 of the first substrate 100. The cover portion 400 on the first bottom surface 11011 of the first substrate 100 may cover the third semiconductor chips 800.

Unlike the embodiment of FIG. 13, the third semiconductor chips 800 may be directly bonded to the second semiconductor chips 300.

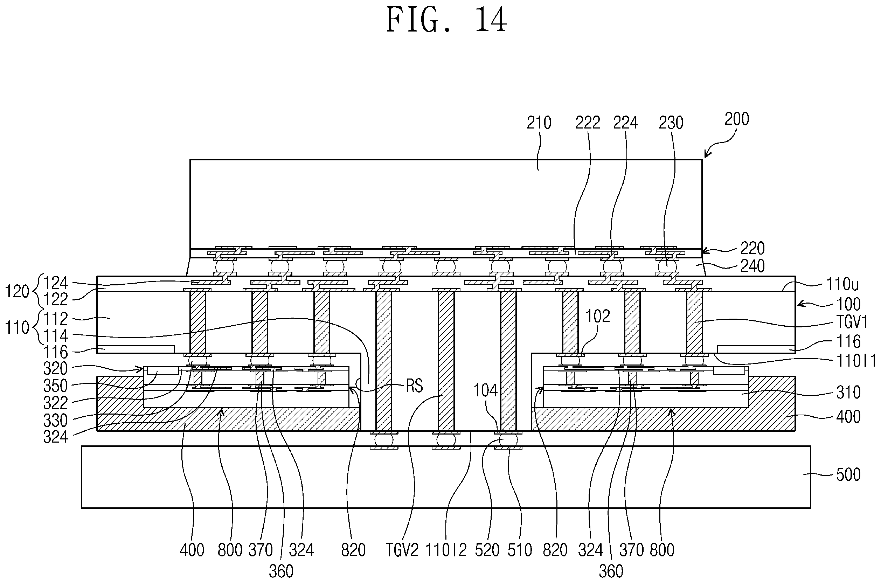

Referring to FIG. 14, the third semiconductor chips 800 may be mounted on the second semiconductor chips 300. In more detail, the third chip pads of the third chip interconnection layer 820 of the third semiconductor chips 800 may be vertically aligned to the fourth chip pads 370 of the second semiconductor chips 300. The second and third semiconductor chips 300 and 800 may be in contact with each other in such a way that the third chip pads and the fourth chip pads 370 are electrically connected to each other.

The third semiconductor chips 800 may be connected to the second semiconductor chips 300. In detail, the third chip pads of the third semiconductor chips 800 may be bonded to the fourth chip pads 370 of the second semiconductor chips 300 at an interface between the second and third semiconductor chips 300 and 800. Here, the third chip pads and the fourth chip pads 370 may form an intermetal hybrid bonding structure. For example, the third chip pads and the fourth chip pads 370 may be bonded to each other to form a single object.

Unlike the embodiments of FIGS. 12 to 14, the third semiconductor chips 800 may be provided as a single module.

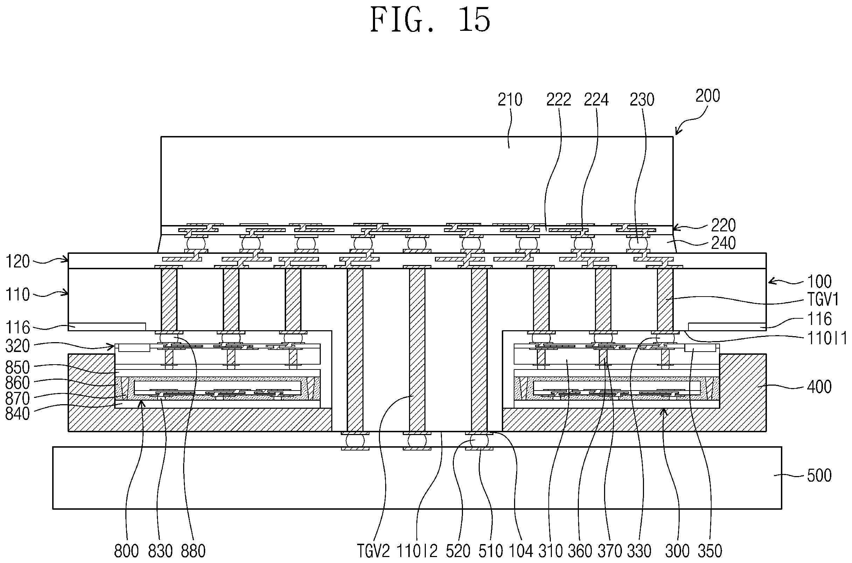

Referring to FIG. 15, the modules may be disposed on the bottom surface of the second semiconductor chips 300. The modules may include a first inner substrate 840, the third semiconductor chips 800, a second inner substrate 850, a mold layer 860, and electrically conductive posts 870. Hereinafter, the structure of the module will be described in more detail with reference to one of the modules.

The first inner substrate 840 may be provided. The first inner substrate 840 may include a printed circuit board (PCB) or a redistribution substrate, which includes signal patterns on a top surface thereof.

The third semiconductor chip 800 may be mounted on the top surface of the first inner substrate 840. The third semiconductor chip 800 may be configured to have substantially the same features as the third semiconductor chips 800 described with reference to FIGS. 12 to 14. The third semiconductor chips 800 may be mounted on the first inner substrate 840 in a flip chip manner. In more detail, the third semiconductor chips 800 may be mounted on the first inner substrate 840 using the third connection terminals 830, which are provided on the third chip pads of the third semiconductor chips 800.

The mold layer 860 may be disposed on the first inner substrate 840. The mold layer 860 on the first inner substrate 840 may cover the third semiconductor chip 800. The mold layer 860 may include an electrically insulating polymer material (e.g., an epoxy molding compound (EMC)).

The second inner substrate 850 may be disposed on the mold layer 860. The second inner substrate 850 may cover a top surface of the mold layer 860. The second inner substrate 850 may include a redistribution substrate.

The conductive posts 870 may be disposed in the mold layer 860. The conductive posts 870 may vertically penetrate the mold layer 860 and connect the first inner substrate 840 to the second inner substrate 850. The third semiconductor chip 800 may be electrically connected to the second inner substrate 850 through the first inner substrate 840 and the conductive posts 870.

The modules may be disposed on the bottom surface of the second semiconductor chips 300.

The modules may be mounted on the second semiconductor chips 300. For example, module terminals 880 may be provided on the second inner substrate 850 of the modules. The modules may be electrically connected to the second semiconductor chips 300 through the module terminals 880. The module terminals 880 may be provided between the second inner substrate 850 of the modules and the fourth chip pads 370 of the second semiconductor chips 300. The modules may be electrically connected to the chip vias 360 of the second semiconductor chips 300 through the third connection terminals 830.

The cover portion 400 may be disposed on the first bottom surface 11011 of the first substrate 100. The cover portion 400 on the first bottom surface 11011 of the first substrate 100 may cover the modules, in particular, the first inner substrate 840 of the modules.

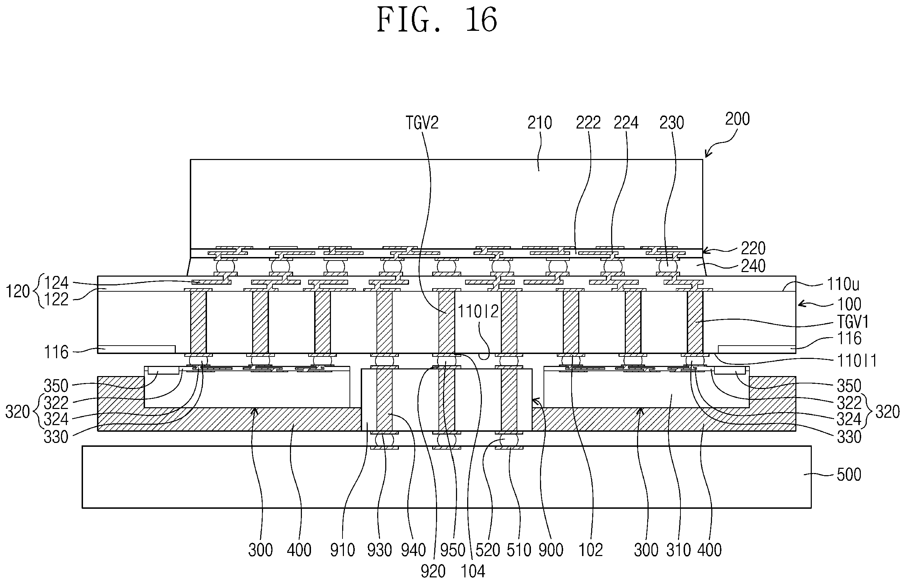

FIG. 16 is a sectional view illustrating a semiconductor package according to some embodiments.

Referring to FIG. 16, the first core portion 110 may have a plate-shaped structure. For example, the first core portion 110 may have the horizontal portion 112 but may not have the protruding portion 114 (e.g., see FIG. 1) protruding from the horizontal portion 112, unlike the embodiment of FIGS. 1 to 15. The first core portion 110 may have a single flat bottom surface. In some embodiments, the first and second bottom surfaces 11011 and 110l2 of the first core portion 110 may be located at the same vertical level.

A vertical connecting portion 900 may be provided on the first bottom surface 11011 of the first core portion 110. The vertical connecting portion 900 may be provided between the second semiconductor chips 300 and may be used for vertical interconnection between the first substrate 100 and the second substrate 500. The protruding portion 114 (e.g., see FIG. 1) of the first core portion 110 may be used as the vertical connecting portion in the embodiments of FIGS. 1 to 15. The vertical connecting portion 900 may be placed between the second semiconductor chips 300. The cover portion 400 may surround the vertical connecting portion 900. The bottom surface of the cover portion 400 may be located at the same vertical level as a bottom surface of the vertical connecting portion 900. The vertical connecting portion 900 may have a second core portion 910, fifth substrate pads 920, sixth substrate pads 930, and a third via 940.

The second core portion 910 may include an electrically insulating material. For example, the second core portion 910 may include glass fibers. Alternatively, the second core portion 910 may include an electrically insulating polymer.

The fifth substrate pads 920 may be provided on a top surface of the second core portion 910. The sixth substrate pads 930 may be provided on a bottom surface of the second core portion 910. The third vias 940 may vertically penetrate the second core portion 910 and may connect the fifth substrate pads 920 to the sixth substrate pads 930.

The vertical connecting portion 900 may be mounted on the first substrate 100. For example, fourth connection terminals 950 may be provided on the fifth substrate pads 920 of the vertical connecting portion 900. The vertical connecting portion 900 may be electrically connected to the first substrate 100 through the fourth connection terminals 950. The fourth connection terminals 950 may be provided between the fifth substrate pads 920 of the vertical connecting portion 900 and the second substrate pads 104, which are provided on the second bottom surface 110l2 of the first substrate 100. The third semiconductor chips 800 may be electrically connected to the second vias TGV2 of the first substrate 100 through the fourth connection terminals 950.

The vertical connecting portion 900 may be mounted on the second substrate 500. For example, the vertical connecting portion 900 may be electrically connected to the second substrate 500 through the third connection terminals 520. The third connection terminals 520 may connect the sixth substrate pads 930 of the vertical connecting portion 900 to the third substrate pads 510 of the second substrate 500. The second substrate 500 may be electrically connected to the first substrate 100, the first semiconductor chip 200, and the second semiconductor chips 300 through the third connection terminals 520, the vertical connecting portion 900, and the fourth connection terminals 950.

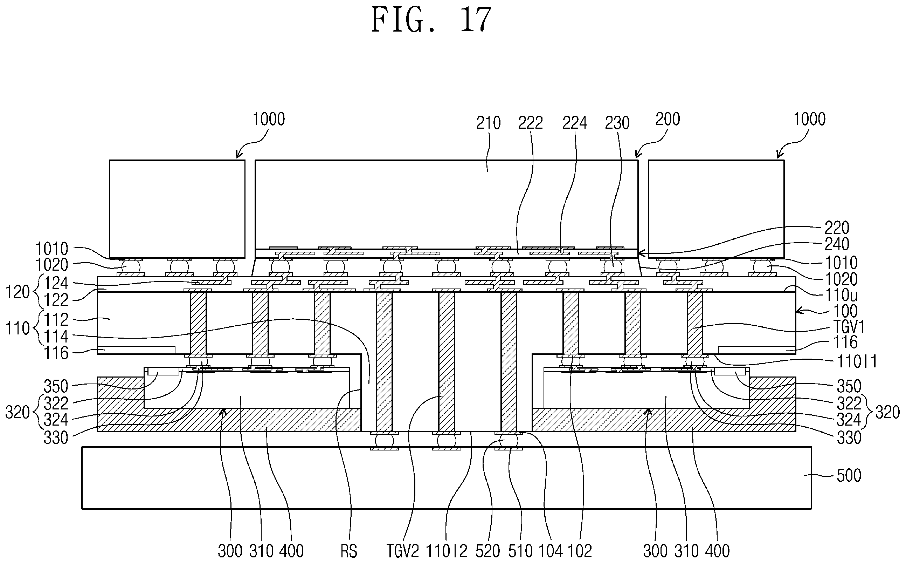

FIG. 17 is a sectional view illustrating a semiconductor package according to some embodiments.

Referring to FIG. 17, the semiconductor package may further include at least one chip stack 1000 mounted on the first substrate 100. The chip stack 1000 may be horizontally spaced apart from the first semiconductor chip 200.

The chip stack 1000 may include a base semiconductor chip, semiconductor chips stacked on the base semiconductor chip, and a mold layer provided on the base semiconductor chip to enclose the semiconductor chips. The base semiconductor chip may be a memory chip (e.g., DRAM, SRAM, MRAM, or FLASH memory chip). In some embodiments, the base semiconductor chip may be a buffer chip, which does not include any integrated circuit and is used for only vertical interconnection. The semiconductor chips may be memory chips (e.g., DRAM, SRAM, MRAM, or FLASH memory chip). The semiconductor chips may be stacked on the base semiconductor chips to form a chip-on-wafer (COW) structure. The chip stack 1000 may include chip stack pads 1010, which are provided on a bottom surface of the base semiconductor chip. The memory chips may be electrically connected to the chip stack pads 1010 through the base semiconductor chip.

The chip stack 1000 may be mounted on the first substrate 100. For example, the chip stack 1000 may be electrically connected to the first substrate 100 through fifth connection terminals 1020. The fifth connection terminals 1020 may be provided between the chip stack pads 1010 of the chip stack 1000 and the first upper substrate pads of the first substrate 100. The chip stack 1000 may be electrically connected to the interconnection layer 120 of the first substrate 100 through the fifth connection terminals 1020.

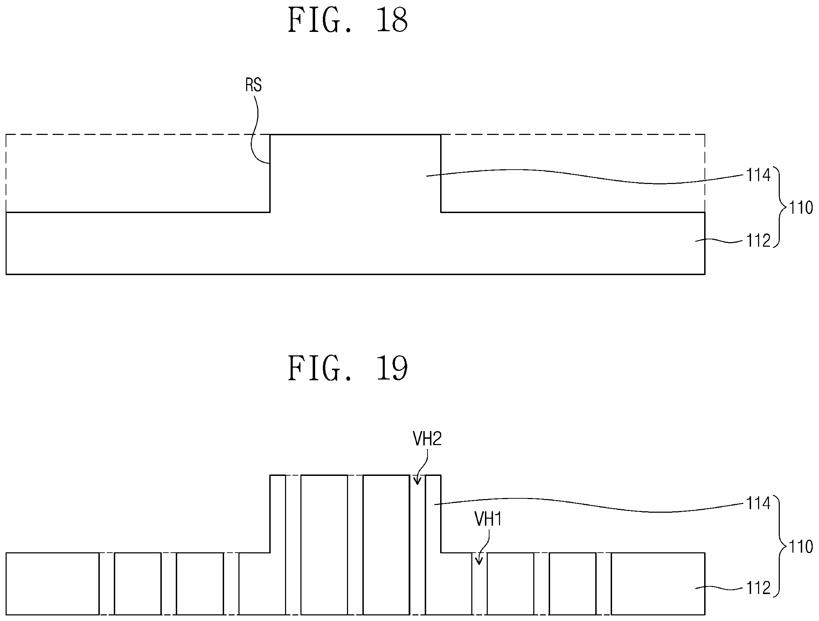

FIGS. 18 to 23 are sectional views illustrating a method of fabricating a semiconductor package according to some embodiments.

Referring to FIG. 18, the first core portion 110 may be provided. The first core portion 110 may include glass fibers.

The recess region RS may be formed by performing an etching process on the first core portion 110. The etching process may be performed along an edge of the first core portion 110, and a center portion of the first core portion 110 may not be etched. After the etching process, the first core portion 110 may have the horizontal portion 112, which has a plate-shaped structure, and the protruding portion 114, which is provided on a center region of the horizontal portion 112 and has a protruding shape. The first core portion 110 may have an inverted T-shaped section.

Referring to FIG. 19, the first core portion 110 may be etched to form first via holes VH1 and second via holes VH2. The first via holes VH1 may be formed next to the protruding portion 114 to vertically penetrate the horizontal portion 112. The first via holes VH1 may be exposed to the outside of the first core portion 110 through top and bottom surfaces of the horizontal portion 112. The second via holes VH2 may vertically penetrate the protruding portion 114 and the horizontal portion 112. The second via holes VH2 may be exposed to the outside of the first core portion 110 through the top surface of the protruding portion 114 and the bottom surface of the horizontal portion 112.

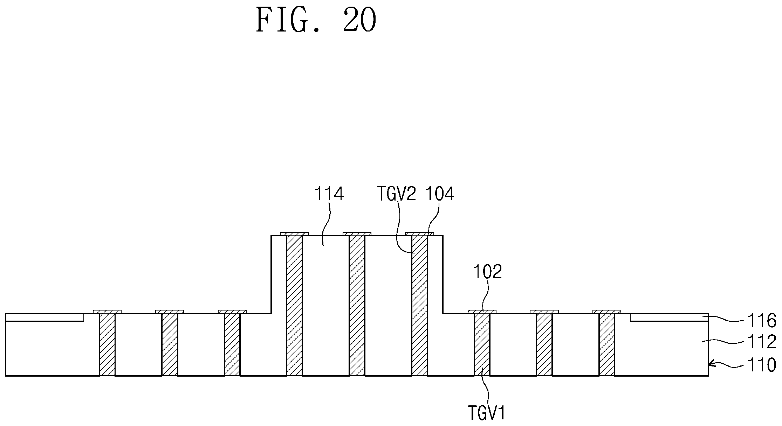

Referring to FIG. 20, the first vias TGV1 may be formed by filling the first via holes VH1 with an electrically conductive material, and the second vias TGV2 may be formed by filling the second via holes VH2 with an electrically conductive material. The top surfaces of the first vias TGV1 may be coplanar with the top surface of the horizontal portion 112. The top surfaces of the second vias TGV2 may be coplanar with the top surface of the protruding portion 114. The bottom surfaces of the first vias TGV1 and the bottom surfaces of the second vias TGV2 may be coplanar with the bottom surface of the horizontal portion 112.

The first substrate pads 102 and the second substrate pads 104 may be formed on the first core portion 110. For example, the first substrate pads 102 and the second substrate pads 104 may be formed by forming and patterning an electrically conductive layer on the first core portion 110. The first substrate pads 102 may be coupled to the top surfaces of the first vias TGV1. The second substrate pads 104 may be coupled to the top surfaces of the second vias TGV2.

The waveguides 116 may be formed in the first core portion 110. For example, the waveguides 116 may be formed by performing an ion exchange process on the first core portion 110. In more detail, a process of precipitating a solution, which contains ions different from a material of the first core portion 110, or an ion implantation process may be performed on a region of the first core portion 110, in which the waveguides 116 will be formed. As a result of the process, some of elements in the glass forming the waveguides 116 may be substituted with other elements. As an example, the waveguides 116 may be formed of or include glass in which a +1 alkali element is substituted with another +1 element.

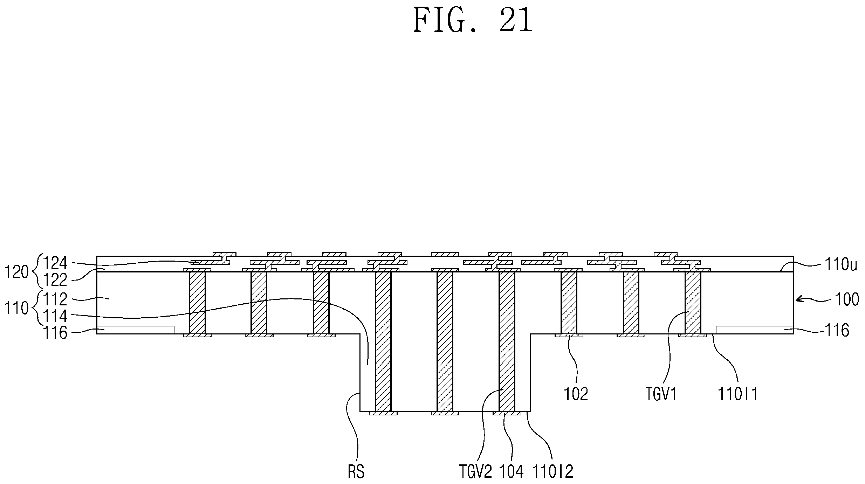

Referring to FIG. 21, the interconnection layer 120 may be formed on the first core portion 110. As an example, the first core portion 110 may be vertically inverted in such a way that the protruding portion 114 is placed below the horizontal portion 112. An electrically insulating layer may be formed to cover the top surface 110u of the first core portion 110 and then may be patterned to form the first insulating layer 122. An electrically conductive layer may be formed on the first insulating layer 122 and then may be patterned to form the first interconnection portion 124. The process of forming and patterning the insulating and electrically conductive layers may be repeated to form the first insulating layer 122 and the first interconnection portion 124.

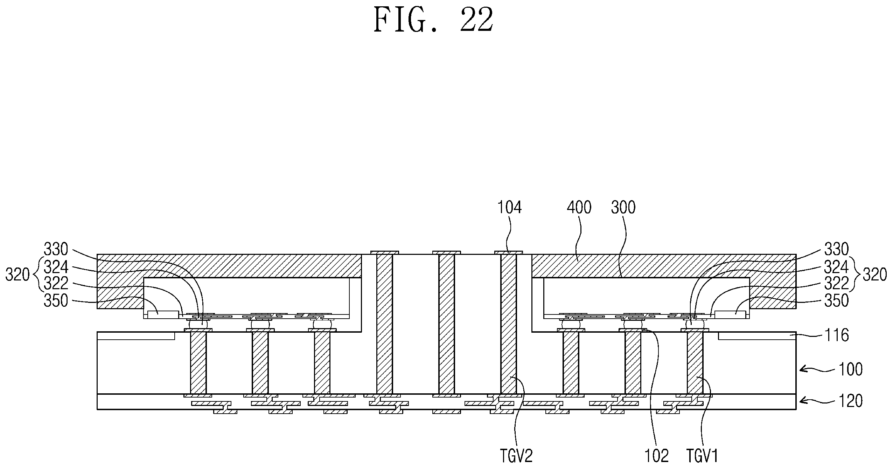

Referring to FIG. 22, the first core portion 110 may be inverted in such a way that the protruding portion 114 is placed on the horizontal portion 112. The second semiconductor chips 300 may be mounted on the first substrate 100. The second semiconductor chips 300 may be configured to have substantially the same features as the second semiconductor chips 300 described with reference to FIGS. 1 to 17. The second semiconductor chips 300 may be mounted on the first substrate 100 in a flip chip manner. In more detail, the second connection terminals 330 may be provided on the second chip pads of the second semiconductor chips 300. The second semiconductor chips 300 may be disposed on the first substrate 100 in such a way that the second connection terminals 330 are aligned to the first substrate pads 102 of the first substrate 100 and the sensor units 350 are aligned to the waveguides 116. The second connection terminals 330 may be in contact with the first substrate pads 102. Thereafter, a reflow process may be performed on the second connection terminals 330 to electrically connect the second connection terminals 330 to the first substrate pads 102 and the second chip pads.

The cover portion 400 may be disposed on the first substrate 100. The cover portion 400 may be configured to have substantially the same features as the cover portion 400 described with reference to FIGS. 1 to 17. The cover portion 400 may cover top surfaces and outer side surfaces of the second semiconductor chips 300. Although not shown, the cover portion 400 may be attached to the top surface of the second semiconductor chips 300 using an adhesive agent.

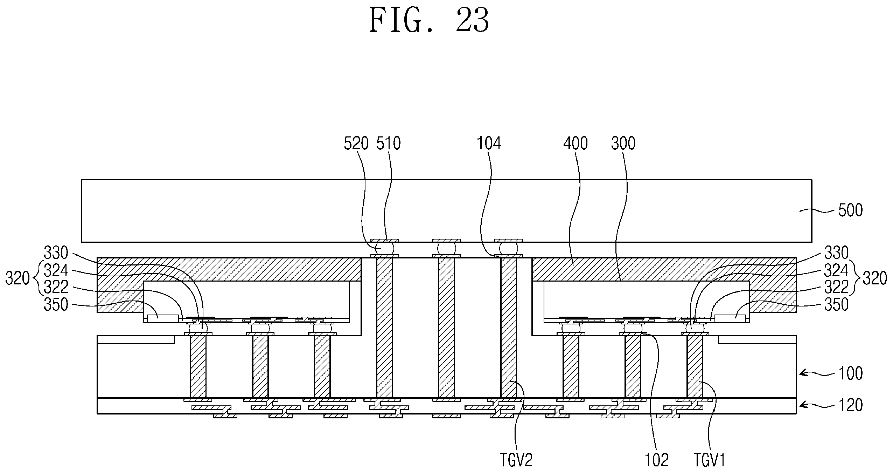

Referring to FIG. 23, the second substrate 500 may be provided. The second substrate 500 may be configured to have substantially the same features as the second substrate 500 described with reference to FIGS. 1 to 17. The first substrate 100 may be mounted on the second substrate 500. In more detail, the third connection terminals 520 may be provided on the third substrate pads 510 of the second substrate 500. The second substrate 500 may be disposed on the first substrate 100 in such a way that the third connection terminals 520 are aligned to the second substrate pads 104 of the first substrate 100. The third connection terminals 520 may be in contact with the second substrate pads 104. Next, a reflow process may be performed on the third connection terminals 520 to electrically connect the third connection terminals 520 to the second and third substrate pads 104 and 510.

Referring back to FIG. 1, the structure of FIG. 23 may be vertically inverted in such a way that the first substrate 100 is placed on the second substrate 500.

The first semiconductor chip 200 may be provided. The first semiconductor chip 200 may be configured to have substantially the same features as the first semiconductor chip 200 described with reference to FIGS. 1 to 17. The first semiconductor chip 200 may be mounted on the first substrate 100. In more detail, the first connection terminals 230 may be provided on the first chip pads of the first semiconductor chip 200. The first semiconductor chip 200 may be disposed on the first substrate 100 in such a way that the first connection terminals 230 are aligned to the first upper substrate pads of the first substrate 100. The first connection terminals 230 may be in contact with the first upper substrate pads. Thereafter, a reflow process may be performed on the first connection terminals 230 to connect the first connection terminals 230 to the first chip pads and the first upper substrate pads.

According to some embodiments, a semiconductor package may include a first substrate, which is configured to provide an optical path from an outside toward second semiconductor chips and an electrical path from the second semiconductor chips toward a first semiconductor chip, and thus, the semiconductor package may have a simple structure, a small size, and an increased integration density.

Since a recess region is formed in the first substrate and second semiconductor chips are placed within the recess region, a distance from a top surface of the first substrate to bottom surfaces of the second semiconductor chips or a distance from the top surface of the first substrate to a second bottom surface of the first substrate may be reduced. Thus, it may be possible to reduce the size of the semiconductor package.

In addition, it may be possible to reduce a thickness of the first substrate between the second semiconductor chips and the first semiconductor chip and thereby to reduce a vertical height of first vias connecting the second semiconductor chips to the first semiconductor chip. That is, since a length of an electric connection path between the second semiconductor chips and the first semiconductor chip is reduced, it may be possible to improve the electrical characteristics of the semiconductor package.

Since a cover portion constituting a socket is used to fasten the second semiconductor chips to a bottom surface of the first substrate, the structural stability of the semiconductor package may be improved. In addition, since the cover portion is formed of a material with a high thermal conductivity, heat, which is generated from the second semiconductor chips, may be easily exhausted to the outside through the cover portion. Thus, it may be possible to improve the heat-dissipation efficiency of the semiconductor package.

Whilst specific embodiments are described, in which various features are changed, it will be appreciated that the teaching of these embodiments may be combined in various ways beyond those explicitly described herein. For instance, the modules of FIG. 15 may be implemented in combination with the chip stacks 1000 of FIG. 17. In addition or alternatively, the third semiconductor chip 800 of FIG. 12 may be implemented with the intermetal hybrid bonding method of FIG. 8. Similarly, the features of FIGS. 1-3 and 7-23 may be implemented with the L-shaped structure of FIG. 4.

Embodiments are set out in the following Clauses:
Clause 1. A semiconductor package, comprising:
   a first substrate having a first bottom surface and a second bottom surface, which are located at different vertical levels from a top surface of the first substrate;
   a first semiconductor chip mounted on the top surface of the first substrate;
   a second semiconductor chip mounted on the first bottom surface of the first substrate, the second semiconductor chip including a photonic integrated circuit; and
   a second substrate disposed on the second bottom surface of the first substrate to cover the second semiconductor chip;
   wherein the first substrate includes:
      a first via vertically penetrating the first substrate and electrically connecting the first semiconductor chip to the second semiconductor chip;
      a second via vertically penetrating the first substrate and electrically connecting the first semiconductor chip to the second substrate; and
      an optical waveguide on the first bottom surface; and
   wherein a first distance from the top surface of the first substrate to the first bottom surface is smaller than a second distance from the top surface of the first substrate to the second bottom surface.
Clause 2. The semiconductor package of Clause 1, wherein:
   at least a portion of the second semiconductor chip is vertically overlapped with a portion of the optical waveguide; and
   the second semiconductor chip is optically coupled to the optical waveguide.
Clause 3. The semiconductor package of Clause 1 or Clause 2, wherein:
   the first bottom surface surrounds the second bottom surface, when viewed in a plan view; and
   the first substrate has a T-shaped section.
Clause 4. The semiconductor package of any of Clauses 1-2, wherein:
   the second bottom surface is spaced horizontally apart from the first bottom surface; and
   the first substrate has an inverted L-shaped section.
Clause 5. The semiconductor package of any preceding Clause, wherein:
   a portion of the first substrate next to the second semiconductor chip protrudes from the first bottom surface; and
   a bottom surface of the portion of the first substrate is the second bottom surface.
Clause 6. The semiconductor package of any preceding Clause, wherein the second substrate includes a printed circuit board or a redistribution substrate.
Clause 7. The semiconductor package of any preceding Clause, wherein:
   the first substrate includes an interconnection layer provided on the top surface of the first substrate;
   the first via and the second via is electrically connected to the interconnection layer; and
   the first semiconductor chip is mounted on the interconnection layer.
Clause 8. The semiconductor package of any preceding Clause, wherein:
   the first via is exposed to a region on the first bottom surface; and
   the second via is exposed to a region on the second bottom surface.
Clause 9. The semiconductor package of any preceding Clause, further including a third semiconductor chip mounted on the first bottom surface of the first substrate, wherein:
   the third semiconductor chip is horizontally spaced apart from the second semiconductor chip; and
   the third semiconductor chip includes an electronic integrated circuit.
Clause 10. The semiconductor package of any preceding Clause, further including a cover portion provided on the first bottom surface to cover the second semiconductor chip; wherein:
   beside the second semiconductor chip, the cover portion is vertically spaced apart from the optical waveguide; and
   a space between the optical waveguide and the cover portion constitutes a socket.
Clause 11. The semiconductor package of any preceding Clause, wherein a bottom surface of the second semiconductor chip and the second bottom surface of the first substrate are in contact with a top surface of the second substrate.
Clause 12. The semiconductor package of Clause 11, wherein:
   the second semiconductor chip includes a third via vertically penetrating the second semiconductor chip; and
   the third via is electrically connected to the second substrate.
Clause 13. The semiconductor package of any of Clauses 1-10, further including a fourth semiconductor chip provided between the second semiconductor chip and the second substrate, wherein:
   the fourth semiconductor chip is mounted on a bottom surface of the second semiconductor chip;
   the second semiconductor chip includes a fourth via, which vertically penetrates the second semiconductor chip and is electrically connected to the fourth semiconductor chip: and
   the fourth semiconductor chip includes an electronic integrated circuit.
Clause 14. The semiconductor package of any preceding Clause, wherein an active surface of the second semiconductor chip is in contact with the first bottom surface of the first substrate.
Clause 15. The semiconductor package of any preceding Clause, wherein:
   an active surface of the second semiconductor chip faces the first bottom surface of the first substrate; and
   the second semiconductor chip is mounted on the first substrate using connection terminals, which are provided between the second semiconductor chip and the first substrate.
Clause 16. The semiconductor package of any preceding Clause, wherein the first semiconductor chip includes a logic chip.
Clause 17. The semiconductor package of any preceding Clause, wherein the first substrate includes glass.
Clause 18. A semiconductor package, comprising:
   a first substrate including a core portion formed of glass and an interconnection layer on a top surface of the core portion, the core portion having a recess region, which is formed on a bottom surface of the core portion and is in contact with a side surface of the core portion;
   a first semiconductor chip disposed on the interconnection layer;
   a second semiconductor chip disposed on a bottom surface of the recess region, the second semiconductor chip including a photonic integrated circuit;
   a cover portion on the bottom surface of the recess region to cover the second semiconductor chip; and
   a second substrate covering a bottom surface of the cover portion and the bottom surface of the core portion;
   wherein:
      the bottom surface of the core portion is located at a level lower than the bottom surface of the cover portion;
      the core portion includes an optical waveguide provided on the bottom surface of the recess region;
      the optical waveguide extends toward the side surface of the core portion from a first region between the second semiconductor chip and the core portion to a second region beside the second semiconductor chip; and
      the second semiconductor chip is optically coupled to the optical waveguide.
Clause 19. The semiconductor package of Clause 18, wherein the first substrate further includes:
   a first via, which vertically penetrates the core portion, is exposed to regions on the top surface of the core portion and the bottom surface of the recess region, and is electrically connected to the interconnection layer; and
   a second via, which vertically penetrates the core portion, is exposed to regions on the top surface of the core portion and the bottom surface of the core portion, and is electrically connected to the interconnection layer.
Clause 20. The semiconductor package of Clause 19, wherein the second semiconductor chip is mounted on the bottom surface of the recess region of the first substrate and is electrically connected to the first via.
Clause 21. The semiconductor package of Clause 19, wherein:
   the second substrate is mounted on the bottom surface of the core portion; and
   the second substrate is electrically connected to the second via.
Clause 22. The semiconductor package of any of Clauses 18-21, wherein a bottom surface of the second semiconductor chip and the bottom surface of the core portion are in contact with a top surface of the second substrate.
Clause 23. The semiconductor package of Clause 22, wherein the second semiconductor chip includes a third via vertically penetrating the second semiconductor chip, and the third via is electrically connected to the second substrate.
Clause 24. The semiconductor package of any of Clauses 18-23, wherein a first distance from the top surface of the core portion to the bottom surface of the recess region is smaller than a second distance from the top surface of the core portion to the bottom surface of the core portion.
Clause 25. The semiconductor package of any of Clauses 18-24, wherein:
   the recess region is provided along an edge of the core portion, when viewed in a plan view; and
   the first substrate has a T-shaped section.
Clause 26. The semiconductor package of any of Clauses 18-24, wherein:
   the recess region is provided adjacent to the side surface of the core portion; and
   the first substrate has an inverted L-shaped section.
Clause 27. The semiconductor package of any of Clauses 18-26, wherein:
   the cover portion next to the second semiconductor chip is vertically spaced apart from the optical waveguide; and
   a space between the optical waveguide and the cover portion constitutes a socket.
Clause 28. A semiconductor package, comprising:
   a first substrate;
   a first semiconductor chip mounted on a top surface of the first substrate;
   second semiconductor chips mounted on a bottom surface of the first substrate;
   a second substrate on bottom surfaces of the second semiconductor chips;
   a vertical connecting portion between the second semiconductor chips and electrically connecting the first substrate to the second substrate; and
   cover portions disposed between the first substrate and the second substrate,
   wherein:
      the first substrate includes optical waveguides on the bottom surface of the first substrate;
      the optical waveguides extend from first regions overlapping the second semiconductor chips to second regions beside the second semiconductor chips;
      the cover portions are disposed on respective portions of the second semiconductor chips;
      the cover portions are vertically spaced apart from the optical waveguides, and
      spaces between the optical waveguides and the cover portions constitute sockets.
Clause 29. The semiconductor package of Clause 28, wherein the first substrate includes:
   a protruding portion protruding to a region on the bottom surface of the first substrate; and
   a first via vertically penetrating the first substrate and exposed to a region on a bottom surface of the protruding portion;
   wherein the protruding portion and the first via constitute the vertical connecting portion.
Clause 30. The semiconductor package of Clause 28, wherein:
   the vertical connecting portion includes a third substrate between the second semiconductor chips;
   the third substrate is mounted on the bottom surface of the first substrate, between the second semiconductor chips; and
   the second substrate is mounted on a bottom surface of the third substrate.
Clause 31. The semiconductor package of Clause 30, wherein:
   the first substrate includes a second via, which vertically penetrates the first substrate and is exposed to a region on the bottom surface of the first substrate; and
   the third substrate is electrically connected to the second via.
Clause 32. The semiconductor package of any of Clauses 28-31, wherein:
   the first substrate includes third vias, which are disposed on the second semiconductor chips, vertically penetrate the first substrate, and are exposed to a region on the bottom surface of the first substrate; and
   the second semiconductor chips are electrically connected to the third vias.
Clause 33. The semiconductor package of any of Clauses 28-32, wherein a bottom surface of the vertical connecting portion is located at a level lower than a bottom surface of the cover portion.
Clause 34. The semiconductor package of any of Clauses 28-33, wherein:
   at least a portion of each of the second semiconductor chips is vertically overlapped with a portion of one of the optical waveguides; and
   the second semiconductor chips are optically coupled to the optical waveguides.
Clause 35. The semiconductor package of any of Clauses 28-34, wherein:
   the vertical connecting portion is disposed on a center portion of the first substrate, when viewed in a plan view; and
   the first substrate has a T-shaped section.
Clause 36. The semiconductor package of any of Clauses 28-35, wherein:
   the first substrate includes an interconnection layer on the top surface of the first substrate; and
   the first semiconductor chip is mounted on the interconnection layer.
Clause 37. The semiconductor package of any of Clauses 28-36, wherein the bottom surfaces of the second semiconductor chips and a bottom surface of the vertical connecting portion are in contact with a top surface of the second substrate.
Clause 38. The semiconductor package of Clause 37, wherein:
   each of the second semiconductor chips includes a fourth via vertically penetrating the second semiconductor chips; and
   the fourth via is electrically connected to the second substrate.
Clause 39. The semiconductor package of any of Clauses 28-36, wherein each of the cover portions extends to a region on the bottom surface of the second semiconductor chip.

Many alterations and modifications may be made by those having ordinary skill in the art, given the benefit of present disclosure, without departing from the scope of the inventive concept(s). Therefore, it must be understood that the illustrated embodiments have been set forth only for the purposes of example, and that it should not be taken as limiting the inventive concept(s) as defined by the following claims. The following claims, therefore, are to be read to include not only the combination of elements which are literally set forth but all equivalent elements for performing substantially the same function in substantially the same way to obtain substantially the same result. The claims are thus to be understood to include what is specifically illustrated and described above, what is conceptually equivalent, and also what incorporates the essential idea of the inventive concept(s).

## Claims

1. A semiconductor package, comprising:
a first substrate having a first bottom surface and a second bottom surface, which are located at different vertical levels from a top surface of the first substrate;
a first semiconductor chip mounted on the top surface of the first substrate;
a second semiconductor chip mounted on the first bottom surface of the first substrate, the second semiconductor chip including a photonic integrated circuit; and
a second substrate disposed on the second bottom surface of the first substrate to cover the second semiconductor chip;
wherein the first substrate includes:
a first via vertically penetrating the first substrate and electrically connecting the first semiconductor chip to the second semiconductor chip;
a second via vertically penetrating the first substrate and electrically connecting the first semiconductor chip to the second substrate; and
an optical waveguide on the first bottom surface; and
wherein a first distance from the top surface of the first substrate to the first bottom surface is smaller than a second distance from the top surface of the first substrate to the second bottom surface.

2. The semiconductor package of claim 1, wherein:
at least a portion of the second semiconductor chip is vertically overlapped with a portion of the optical waveguide; and
the second semiconductor chip is optically coupled to the optical waveguide.

3. The semiconductor package of claim 1 or claim 2, wherein:
the first bottom surface surrounds the second bottom surface, when viewed in a plan view; and
the first substrate has a T-shaped section.

4. The semiconductor package of claim 1 or claim 2, wherein:
the second bottom surface is spaced horizontally apart from the first bottom surface; and
the first substrate has an inverted L-shaped section.

5. The semiconductor package of any preceding claim, wherein:
a portion of the first substrate next to the second semiconductor chip protrudes from the first bottom surface; and
a bottom surface of the portion of the first substrate is the second bottom surface.

6. The semiconductor package of any preceding claim, wherein the second substrate includes a printed circuit board or a redistribution substrate.

7. The semiconductor package of any preceding claim, wherein:
the first substrate includes an interconnection layer provided at the top surface of the first substrate;
the first via and the second via is electrically connected to the interconnection layer; and
the first semiconductor chip is mounted on the interconnection layer.

8. The semiconductor package of any preceding claim, wherein:
the first via is exposed to a region on the first bottom surface; and
the second via is exposed to a region on the second bottom surface.

9. The semiconductor package of any preceding claim, further including a third semiconductor chip mounted on the first bottom surface of the first substrate, wherein:
the third semiconductor chip is horizontally spaced apart from the second semiconductor chip; and
the third semiconductor chip includes an electronic integrated circuit.

10. The semiconductor package of any preceding claim, further including a cover portion provided on the first bottom surface to cover the second semiconductor chip; wherein:
beside the second semiconductor chip, the cover portion is vertically spaced apart from the optical waveguide; and
a space between the optical waveguide and the cover portion constitutes a socket.

11. The semiconductor package of any preceding claim, wherein a bottom surface of the second semiconductor chip and the second bottom surface of the first substrate are in contact with a top surface of the second substrate.

12. The semiconductor package of claim 11, wherein:
the second semiconductor chip includes a third via vertically penetrating the second semiconductor chip; and
the third via is electrically connected to the second substrate.

13. The semiconductor package of any of claims 1-10, further including a fourth semiconductor chip provided between the second semiconductor chip and the second substrate, wherein:
the fourth semiconductor chip is mounted on a bottom surface of the second semiconductor chip;
the second semiconductor chip includes a fourth via, which vertically penetrates the second semiconductor chip and is electrically connected to the fourth semiconductor chip: and
the fourth semiconductor chip includes an electronic integrated circuit.

14. The semiconductor package of any preceding claim, wherein an active surface of the second semiconductor chip is in contact with the first bottom surface of the first substrate.

15. The semiconductor package of any of claims 1-13, wherein:
an active surface of the second semiconductor chip faces the first bottom surface of the first substrate; and
the second semiconductor chip is mounted on the first substrate using connection terminals, which are provided between the second semiconductor chip and the first substrate.
